# EUROPÄISCHE PATENTSCHRIFT

(11) **EP 3 255 173 B1**
(45) Veröffentlichungstag und Bekanntmachung des Hinweises auf die Patenterteilung: **21.11.2018**
(21) Anmeldenummer: 16173075.9
(22) Anmeldetag: 06.06.2016
(51) Int. Cl.: C23C 16/455

(54) **FLUIDTEMPERIERTER GASVERTEILER IN SCHICHTBAUWEISE**
LAYERED GAS DISTRIBUTOR WITH TEMPERATURE-CONTROLLED FLUID
DISTRIBUTEUR DE GAZ TEMPERE PAR FLUIDE STRUCTURE EN COUCHES

(43) Veröffentlichungstag der Anmeldung: 13.12.2017
(73) Patentinhaber: Meyer Burger (Germany) AG, 09337 Hohenstein-Ernstthal (DE)
(72) Erfinder: Pietzsch, Rocco, 08064 Zwickau (DE); Ansorge, Erik, Dr., 09131 Chemnitz (DE); Scheit, Uwe, Dr., 15230 Frankfurt (Oder) (DE); Frendel, Christian, 08451 Crimmitschau (DE)
(74) Vertreter: Kailuweit & Uhlemann Patentanwälte Partnerschaft mbB

(56) Entgegenhaltungen:
- DE-T5-112011 102 327
- US-A1- 2009 104 351
- US-A1- 2013 299 009

## Beschreibung

Die Erfindung betrifft einen Gasverteiler für den Einsatz in Substratbearbeitungskammern, bei denen das einzulassende Gas über eine Fläche verteilt und dabei mit einem Fluid gekühlt oder geheizt wird, und ein Verfahren zum Herstellen eines solchen Gasverteilers. Insbesondere kommt ein solcher Gasverteiler in Beschichtungsanlagen, z.B. bei der Herstellung von Solarzellen, zum Einsatz.

Ein Gasverteiler dient dem Einlass eines oder mehrere Gase aus einem oder mehreren Gasvorratsräumen in eine Bearbeitungskammer bzw. den Bearbeitungsraum und der spezifischen, meist homogenen, Verteilung des oder der Gase über eine spezifische Fläche. Diese Fläche entspricht im Wesentlichen der mit dem entsprechenden Bearbeitungsschritt zu bearbeitenden Fläche eines Substrates, kann aber auch größer oder kleiner sein. Der Gasverteiler, oft auch Showerhead genannt, weist an seiner dem Substrat zugewandten Oberfläche Öffnungen auf, durch die das oder die Gase austreten bzw. ausgelassen werden, und an einer anderen Oberfläche mindestens einen Einlass für das oder die Gase, die verteilt werden sollen. Die Öffnungen sollen vorzugsweise sehr klein und dicht sowie homogen über die dem Substrat zugewandte Oberfläche des Gasverteilers verteilt sein, damit die Bearbeitung des Substrates homogen erfolgen kann. Oftmals liegen in der Bearbeitungskammer Temperaturen zwischen 600°C und 1250°C vor. Die durch die hohen Temperaturen erzeugte Verbiegung des Gasverteilers kann zu einer inhomogenen Bearbeitung des Substrates, insbesondere zu einem inhomogenen Beschichten oder Entfernen von Schichten, führen, da die Gasverteilung nicht mehr homogen erfolgt und die Abstände zwischen den Gasauslassöffnungen und dem Substrat über das Substrat hinweg variieren. Darüber hinaus können hohe Temperaturen im Gasverteiler eine Reaktion des einzulassenden Gases mit den Materialien des Gasverteilers und/oder mit anderen Gasen auslösen, wodurch es zum einen zu einer Verringerung des zur Substratbearbeitung zur Verfügung stehenden Gasvolumens und zweitens zu Ablagerungen im Gasverteiler und damit zu Behinderungen des Gasauslasse kommen kann. Um diese Effekte zu vermeiden oder zumindest zu verringern, wird der Gasverteiler oftmals gekühlt. Jedoch ist auch eine gezielte Beheizung des Gasverteilers möglich.

Bekannte Gasverteiler weisen bspw. einen monolithischen, massiven Block eines Materials, z.B. Metall, auf, in den durch Drahterodieren oder andere Verfahren sowohl die Gaskanäle mit den Gasauslassöffnungen als auch quer dazu verlaufende Temperierkanäle eingebracht werden. Dabei können jedoch nur geradlinig verlaufende Temperierkanäle erzeugt werden, die durch relativ dicke Materialwände von den Gaskanälen getrennt sind. Dadurch ist die Dichte der Gaskanäle und Gasauslassöffnungen auf ein niedriges Niveau begrenzt, während gleichzeitig die Durchflussmenge durch die Temperierkanäle und damit der Grad der erreichbaren Temperierung ebenfalls begrenzt sind.

Die US 2013/0299009 A1 beschreibt einen Gasverteiler zur Verteilung von mindestens zwei verschiedenen Gasen, der eine Kühlplatte und eine Gasverteilplatte beinhaltet. Die Kühlplatte weist Kühlkanäle, die entweder als Tunnel im Materialinneren oder als Gräben in der Oberfläche der Kühlplatte ausgebildet sind, sowie Gaskanäle auf, die mit Öffnungen bzw. Gaskanälen in der Gasverteilplatte korrespondieren. Die Gasverteilplatte liegt dicht an der Oberfläche der Kühlplatte an, so dass die Gaskanäle der Kühlplatte und die Öffnungen bzw. Gaskanäle in der Gasverteilplatte den Gastransport aus einem Gasvorratsraum zu einem Bearbeitungsraum ermöglichen.

Aus der DE 10 2007 026 349 A1 ist ein Gasverteiler bekannt, der aus vielen dünnen Blechplatten aufgebaut wird. In den Blechplatten ist jeweils eine Vielzahl von Ringscheiben mit je einem Loch in der Mitte angeordnet, die durch das Übereinanderanordnen der Blechplatten dann Gaskanäle als Röhrchen ausbilden. Da die Ringscheiben in den Blechplatten, die nicht die Oberflächen des Gasverteilers bilden, durch Stege verbunden sind, die eine geringere Materialstärke als die Platte selbst aufweisen, entstehen zwischen den Röhrchen der Gaskanäle Hohlräume, die mit einem Kühlmedium durchströmt werden können.

Nachteilig an den letzten beiden Gasverteilern ist die Notwendigkeit, die einzelnen Platten mit den darin für den Gastransport enthaltenen Löchern bzw. Ringscheiben sehr präzise zueinander zu justieren, um die Dichtheit der Gaskanäle und eine geringe Wandrauheit der Gaskanäle zu erreichen. Somit ist ein hoher fertigungstechnischer Aufwand zur Herstellung des Gasverteilers notwendig. Darüber hinaus weist insbesondere der Gasverteiler der DE 10 2007 026 349 A1 sehr viele diskrete, dreidimensionale Fügestellen, die bei einem Verbindungsvorgang der einzelnen Platten durch Löten oder Schweißen entstehen, auf, wodurch die Anforderungen an die Qualität des Verbindungsvorganges weiter steigen.

Es ist daher Aufgabe der Erfindung, einen Gasverteiler bereitzustellen, der sowohl eine hervorragende Temperierung der hindurchtretenden Gase und des Gasverteilers und eine homogene, dichte Verteilung kleiner Gasauslassöffnungen als auch eine einfache Möglichkeit zur Herstellung eines solchen Gasverteilers erlaubt.

Diese Aufgabe wird gelöst durch einen Gasverteiler gemäß Anspruch 1 und ein Verfahren zur Herstellung eines solchen Gasverteilers gemäß Anspruch 9. Vorteilhafte Ausgestaltungen und Ausführungsformen finden sich in den Unteransprüchen.

Der erfindungsgemäße Gasverteiler enthält eine Bodenplatte, eine Temperierplatte, eine Deckplatte, mindestens einen Temperierfluidzufuhraufsatz und mindestens einen Temperierfluidauslassaufsatz. Dabei weisen die Bodenplatte, die Temperierplatte und die Deckplatte denselben Umriss auf, sie sind in der Draufsicht vorzugsweise deckungsgleich, so dass die Kanten der Platten übereinander abschließen. Die Platten haben laterale Ausdehnungen, die wesentlich größer als die Dicke der einzelnen Platten ist. Dabei können die Platten gleich dick oder verschieden dick sein. Die Dicke einer Platte wird in die Richtung gemessen, in die mindestens eine andere Platte an die jeweilige Platte angrenzt. Vorzugsweise sind die Bodenplatte und die Deckplatte dünn ausgebildet, während die Temperierplatte dicker als die Bodenplatte und/oder die Deckplatte ausgebildet und vorzugsweise die dickste Platte des ganzen Gasverteilers ist. Die Temperierplatte ist zwischen der Bodenplatte und der Deckplatte angeordnet, und aufeinanderliegende Platten sind durch ein Fügeverfahren gasdicht miteinander verbunden. Die Bodenplatte weist Gasauslassöffnungen auf, die die Bodenplatte vollständig durchdringen. Die Temperierplatte weist Temperierkanälen auf, die als voneinander durch Stege getrennte Durchbrüche durch die Temperierplatte ausgebildet sind, wobei die Temperierkanäle erste Enden an einer ersten Seite und zweite Enden an einer zweiten Seite der Temperierplatte aufweisen, jedoch nicht vollständig bis zur jeweiligen Seite reichen. Die zweite Seite der Temperierplatte liegt der ersten Seite in einer Draufsicht auf die Temperierplatte gegenüber. In den Stegen der Temperierplatte sind durchgehende Steglöcher ausgebildet, die mit den Gasauslassöffnungen der Bodenplatte korrespondieren. Die Deckplatte weist Gaseinlassöffnungen auf, die die Deckplatte vollständig durchdringen und mit mindestens einem Teil der Steglöcher der Temperierplatte korrespondieren. Darüber hinaus weist die Deckplatte mindestens einen Temperierfluidverteiler, der als Durchbruch in der Deckplatte ausgeführt ist und die ersten Enden aller mit ihm korrespondierender Temperierkanäle überdeckt, sowie mindestens einen Temperierfluidsammler auf, der als Durchbruch in der Deckplatte ausgeführt ist und die zweiten Enden aller mit ihm korrespondierenden Temperierkanäle überdeckt. Der mindestens eine Temperierfluidzufuhraufsatz, der einen Temperaturfluidzufuhranschluss aufweist, ist gasdicht mit der Deckplatte verbunden und so über einem mit ihm korrespondierenden Temperierfluidverteiler angeordnet, dass er den korrespondierenden Temperierfluidverteiler vollständig bedeckt und ein Temperierfluid vom Temperaturfluidzufuhranschluss durch den korrespondierenden Temperierfluidverteiler in die ersten Enden der korrespondierenden Temperierkanäle strömen kann. Der mindestens eine Temperierfluidauslassaufsatz, der einen Temperaturfluidauslassanschluss aufweist, ist gasdicht mit der Deckplatte verbunden und so über einem mit ihm korrespondierenden Temperierfluidsammler angeordnet, dass er den korrespondierenden Temperierfluidsammler vollständig bedeckt und das Temperierfluid aus den zweiten Enden der korrespondierenden Temperierkanäle durch den korrespondierenden Temperierfluidsammler in den Temperaturfluidauslassanschluss strömen kann.

Unter "korrespondieren" ist zu verstehen, dass die entsprechenden Öffnungen, Löcher und Elemente des Gasverteilers in Dickenrichtung des Gasverteilers übereinander liegen. Bspw. liegen die ersten Seiten aller Platten übereinander. Jeweils eine Gaseinlassöffnung, ein dazu korrespondierendes Stegloch und eine dazu korrespondierende Gasauslassöffnung bilden einen Gaskanal, durch den ein Gas aus einem Gasvorrat oberhalb der Deckplatte in einen Bearbeitungsraum unterhalb der Bodenplatte strömen kann. In ähnlicher Weise bilden die miteinander korrespondierenden Elemente Temperierfluidzufuhraufsatz, Temperierfluidverteiler, Temperierkanäle sowie Temperierfluidsammler und Temperierfluidauslassaufsatz einen Strömungskanal, durch den das Temperierfluid strömt und seine Temperierwirkung im Gasverteiler entfalten kann.

In einer besonderen Ausführungsform weist der Gasverteiler mehrere Temperierfluidzufuhraufsätze, mehrere Temperierfluidverteiler, mindestens einen Temperierfluidsammler und mindestens einen Temperierfluidauslassaufsatz auf. Dabei bedeckt jeder Temperierfluidverteiler nur die ersten Enden einer gewissen Anzahl von Temperierkanälen, die kleiner als die Anzahl aller Temperierkanäle ist. Jeder der Temperierfluidzufuhraufsätze korrespondiert mit mindestens einem der Temperierfluidverteiler und bedeckt diesen vollständig. Damit ist es möglich, durch verschiedene, miteinander korrespondierende Temperierfluidzufuhraufsätze, Temperierfluidverteiler und Temperierkanäle verschiedene Temperierfluide und/oder Temperierfluide mit unterschiedlichen Temperaturen strömen zu lassen. Damit können verschiedene laterale Bereiche des Gasverteilers in unterschiedlichem Maße gekühlt oder erwärmt werden, so dass Temperaturinhomogenitäten im Gasverteiler noch besser ausgeglichen werden können. Bspw. kann ein mittlerer Bereich des Gasverteiler in der Draufsicht weniger stark gekühlt werden als die äußeren Bereiche des Gasverteilers, die durch eine Wärmeaufnahme aus einer warmen Umgebung des Gasverteilers über die Seiten stärker erwärmt werden. Jedoch sind auch andere Steuerungen der Temperierwirkung des jeweiligen Temperierfluids für die verschiedenen Bereiche des Gasverteilers möglich. Darüber hinaus kann auch dasselbe Temperierfluid mit derselben Temperatur in alle Temperierfluidzufuhraufsätze und Temperierfluidverteiler eingespeist werden. Insbesondere bei großen Gasverteilern, die eine große Anzahl von Temperierkanälen aufweisen und die sich über eine große Ausdehnung senkrecht zum Verlauf der Temperierkanäle erstrecken, kann es bei nur einem Temperierfluidzufuhraufsatz und nur einem Temperierfluidverteiler zu einer inhomogenen Verteilung des Temperierfluids über die Ausdehnung des Temperierfluidverteilers hinweg kommen. Dies kann durch die Anordnung von mehreren Temperierfluidzufuhraufsätzen und mehreren Temperierfluidverteilern vermieden werden.

Wird dasselbe Temperierfluid für alle Temperierfluidzufuhraufsätze und Temperierfluidverteiler verwendet, welches jedoch für verschiedene Temperierfluidzufuhraufsätze und Temperierfluidverteiler verschiedene Temperaturen aufweisen kann, so kann nur ein Temperierfluidsammler, der das Temperierfluid aus allen Temperierkanälen abführt, und nur ein Temperierfluidauslassaufsatz vorgesehen sein. Werden jedoch unterschiedliche Temperierfluide in verschiedene Temperierfluidzufuhraufsätze und Temperierfluidverteiler eingespeist, so werden vorteilhafterweise für alle Temperierkanäle, die mit ein und demselben Temperierfluidverteiler korrespondieren, ein separater Temperierfluidsammler und ein mit diesem korrespondierender, separater Temperierfluidauslassaufsatz vorgesehen.

Für den Fall, dass verschiedenen Gase oder Gase aus verschiedenen Gasvorräten mit Hilfe des Gasverteilers verteilt und einem Bearbeitungsraum zugeführt werden sollen, kann der Gasverteiler durch zusätzliche Elemente, bspw. zusätzliche Platten, erweitert werden.

So weist der Gasverteiler in einer spezifischen Ausführungsform zur Verteilung von zwei Gasen neben den bereits erwähnten Elementen noch eine Abdeckplatte, eine Gaszufuhrplatte und mindestens einen ersten Gaszufuhraufsatz auf. Dabei ist die Abdeckplatte zwischen der Temperierplatte und der Deckplatte angeordnet und weist mindestens einen Temperierfluidverteiler und mindestens einen Temperierfluidsammler sowie Gasdurchtrittslöcher auf. Der mindestens eine Temperierfluidverteiler und der mindestens eine Temperierfluidsammler sind jeweils als Durchbruch in der Abdeckplatte ausgeführt und korrespondieren mit dem mindestens einen Temperierfluidverteiler und dem mindestens einen Temperierfluidsammler der Deckplatte. Das heißt, dass die Anzahl der Temperierfluidverteiler in den einzelnen Platten jeweils gleich ist, und auch die Anzahl der Temperierfluidsammler in den einzelnen Platten ist jeweils gleich, wobei die Anzahl der Temperierfluidverteiler und die Anzahl der Temperierfluidsammler voneinander verschieden sein können, wie oben beschrieben wurde. Die Gasdurchtrittslöcher korrespondieren mit den Steglöchern der Temperierplatte und durchdringen die Abdeckplatte vollständig. Die Gaszufuhrplatte ist zwischen der Abdeckplatte und der Deckplatte angeordnet und weist wiederum mindestens einen Temperierfluidverteiler und mindestens einen Temperierfluidsammler sowie eine Mehrzahl von als Durchbrüche durch die Gaszufuhrplatte ausgebildeten und voneinander durch Stege getrennten Gaszufuhrkanälen auf. Der mindestens eine Temperierfluidverteiler und der mindestens eine Temperierfluidsammler sind jeweils als Durchbruch in der Gaszufuhrplatte ausgeführt und korrespondieren mit dem mindestens einen Temperierfluidverteiler und dem mindestens einen Temperierfluidsammler der Deckplatte. Die Gaszufuhrkanäle weisen erste Enden an einer dritten Seite der Gaszufuhrplatte und zweite Enden an einer vierten Seite der Gaszufuhrplatte auf, reichen jedoch nicht vollständig bis zur jeweiligen Seite. Die dritte Seite und die vierte Seite sind verschieden von der ersten und der zweiten Seite und die vierte Seite liegt der dritten Seite gegenüber. Jeder Gaszufuhrkanal überdeckt mindestens ein Gasdurchtrittsloch in der Abdeckplatte, das nicht mit einer Gaseinlassöffnung der Deckplatte korrespondiert. In den Stegen der Gaszufuhrplatte sind Steglöcher ausgebildet, die mit den Gaseinlassöffnungen der Deckplatte und mit den korrespondierenden Gasdurchtrittslöchern in der Abdeckplatte korrespondieren. Darüber hinaus ist in der Deckplatte eine erste Gaszufuhröffnung ausgebildet, die als Durchbruch in der Deckplatte ausgeführt ist und die ersten Enden aller Gaszufuhrkanäle überdeckt. Der erste Gaszufuhraufsatz, der einen Gaszufuhranschluss aufweist, ist gasdicht mit der Deckplatte verbunden und so über der ersten Gaszufuhröffnung angeordnet, dass er die erste Gaszufuhröffnung vollständig bedeckt und ein Gas vom Gaszufuhranschluss durch die erste Gaszufuhröffnung in die ersten Enden der Gaszufuhrkanäle strömen kann.

Damit kann in dieser spezifischen Ausführungsform ein erstes Gas durch die Gaseinlassöffnungen in der Deckplatte sowie die dazu korrespondierenden Steglöcher in der Gaszufuhrplatte, Gasdurchtrittslöcher in der Abdeckplatte, Steglöcher in der Temperierplatte und Gasauslassöffnungen in der Bodenplatte von einem Gasvorrat oberhalb der Deckplatte in einen Bearbeitungsraum unterhalb der Bodenplatte strömen, während gleichzeitig ein zweites Gas durch den Gaszufuhranschluss, den Gaszufuhraufsatz, die Gaszufuhröffnung in der Deckplatte, die Gaszufuhrkanäle in der Gaszufuhrplatte, die nicht mit Gaseinlassöffnungen in der Deckplatte korrespespondierenden und durch einen Gaszufuhrkanal überdeckten Gasdurchtrittslöcher in der Abdeckplatte sowie die dazu korrespondierenden Steglöcher in der Temperierplatte und Gasauslassöffnungen in der Bodenplatte aus einem anderen Gasvorrat in den Bearbeitungsraum unterhalb der Bodenplatte strömen kann. Dabei können die dem ersten Gas zugeordneten Öffnungen und Löcher sowie die dem zweiten Gas zugeordneten Öffnungen und Löcher frei über die laterale Ausdehnung des Gasverteilers angeordnet und verteilt sein. Sie können gleichmäßig verteilt sein oder aber spezifische Muster bilden.

In einer weiteren spezifischen Ausführungsform des Gasverteilers für mehrere Gase weist die Deckplatte eine zweite Gaszufuhröffnung, die als Durchbruch in der Deckplatte ausgeführt ist und die zweiten Enden aller Gaszufuhrkanäle überdeckt, und der Gasverteiler weiterhin einen zweiten Gaszufuhraufsatz auf. Der zweite Gaszufuhraufsatz ist gasdicht mit der Deckplatte verbunden und so über der zweiten Gaszufuhröffnung angeordnet, dass er die zweite Gaszufuhröffnung in der Deckplatte vollständig bedeckt und ein Gas vom Gaszufuhranschluss durch die zweite Gaszufuhröffnung in die zweiten Enden der Gaszufuhrkanäle strömen kann. Damit kann eine gleichmäßigere Zufuhr des zweiten Gases, das nunmehr von beiden Enden der Gaszufuhrkanäle in die Gaszufuhrkanäle strömt, erreicht werden.

Wenn die erste Gaszufuhröffnung und die zweite Gaszufuhröffnung nicht jeweils die Enden aller Gaszufuhrkanäle überdecken, sondern jeweils nur die entsprechenden Enden verschiedener Gaszufuhrkanäle, so kann der erste Gaszufuhraufsatz in Verbindung mit der ersten Gaszufuhröffnung und den Gaszufuhrkanälen, deren erste Enden von der ersten Gaszufuhröffnung überdeckt werden, zur Verteilung eines zweiten Gases und der zweite Gaszufuhraufsatz in Verbindung mit der zweiten Gaszufuhröffnung und den Gaszufuhrkanälen, deren zweite Enden von der zweiten Gaszufuhröffnung überdeckt werden, zur Verteilung eines dritten Gases genutzt werden. Ebenfalls möglich ist auch das Einfügen einer weiteren Abdeckplatte und einer weiteren Gaszufuhrplatte, die in Verbindung mit einem zugeordneten Gaszufuhraufsatz Gaskanäle für ein drittes Gas bilden. Der erfindungsgemäße Gasverteiler ist für die Verteilung weiterer Gase in ähnlicher Weise erweiterbar, wobei beide genannte Möglichkeiten anwendbar sind.

Vorzugsweise sind die Stege in der Temperierplatte aus dem Material der Temperierplatte ausgebildet und weisen in allen Bereichen dieselbe Dicke auf wie die Temperierplatte. Damit ist eine gegenüber einem Temperierfluid dichte Verbindung zwischen der Temperierplatte und der Bodenplatte und der Deckplatte möglich. Darüber hinaus sind die einzelnen Temperierkanäle weitgehend voneinander isoliert und stehen nur über den Temperierfluidverteiler und den Temperierfluidsammler miteinander in Verbindung. Des Weiteren ist die Stabilität der Temperierplatte und des gesamten Gasverteilers erhöht.

Gleiches ist vorzugsweise auch auf die Stege in der Gaszufuhrplatte zwischen den Gaszufuhrkanälen anwendbar, d.h. die Stege in der Gaszufuhrplatte haben in allen Bereichen dieselbe Dicke wie die Gaszufuhrplatte.

Vorzugsweise sind die Temperierkanäle geradlinig zwischen ihren ersten und zweiten Enden ausgebildet. Das heißt, dass es keine Kehren, Knicke oder größere Richtungsänderungen im Strömungsverlauf im Temperierkanal gibt. Damit bilden sich ideale Strömungsverhältnisse aus, die eine effektive Temperierung ermöglichen.

Darüber hinaus ist der Abstand zwischen der ersten Seite der Temperierplatte und der zweiten Seite der Temperierplatte die kürzeste laterale Abmessung der Temperierplatte. Wenn die Temperierkanäle entlang dieses Abstandes (also senkrecht zu der ersten und der zweiten Seite der Temperierplatte) von der ersten zur zweiten Seite der Temperierplatte verlaufen, können sie damit mit einer minimalen Länge bei gleichzeitiger Ausdehnung über fast die gesamte Ausdehnung des Gasverteilers in diese Richtung ausgebildet werden. Damit strömt das Fluid nur kurz durch den Gasverteiler und ändert seine Temperatur zwischen der ersten Seite des Gasverteilers und der zweiten Seite des Gasverteilers nicht wesentlich, so dass eine gleichmäßige Temperierung des Gasverteilers entlang der Ausdehnung zwischen der ersten und der zweiten Seite des Gasverteilers erreicht werden kann.

Vorzugsweise weisen die Stege in der Temperierplatte in den Bereichen, in denen ein Stegloch ausgebildet ist, eine größere Breite auf als in anderen Bereichen. Das heißt, die Stege weisen verbreiterte Bereiche auf, in denen jeweils ein Stegloch ausgebildet ist. Damit ist ein großes Volumen des Temperierfluids in den Temperierkanälen bei gleichzeitig großer mechanischer Stabilität der Stege und einer ausreichend dicken Wandstärke der Wand eines Steglochs gegeben. Darüber hinaus vergrößert sich dadurch die Mantelfläche des Bereiches, in dem das Stegloch ausgebildet ist, so dass das durch das Stegloch strömende Gas optimal temperiert werden kann. Die Breite eines Steges wird senkrecht zur Verlaufsrichtung eines Temperierkanals und zwischen zwei benachbartenTemperierkanälen gemessen.

Vorzugsweise ist die Breite des Materials der Temperierplatte, das sich zwischen zwei benachbarten Temperierkanälen befindet, größer als oder gleich der Breite des Materials der Temperierplatte, die sich zwischen einem Temperierkanal und einem Stegloch befindet. Damit wird das durch das Stegloch strömende Gas optimal temperiert, während gleichzeitig die mechanische Stabilität der Stege und Temperierkanäle gewährleistet wird.

Bei der Wahl der Breite des Stegmaterials sowohl im Bereich zwischen zwei benachbarten Temperierkanälen als auch im Bereich zwischen einem Temperierkanal und einem Stegloch wird ein Optimum zwischen einer genügend großen Stegbreite zur Reduzierung der Leckrate und einer genügend kleinen Stegbreite zur Verbesserung der Temperierwirkung des Temperierfluids auf das durch das Stegloch strömende Gas angestrebt. Wie später mit Bezug auf das Verfahren beschrieben wird, werden die Steglöcher erst nachträglich in die Stege der Temperierplatte eingebracht, so dass die Stege - zumindest im Bereich der auszubildenden Steglöcher - breit genug sein müssen, um mit dem genutzten Verfahren zum Einbringen der Löcher eine sichere Abgrenzung des Steglochs zu einem benachbarten Temperierkanal zu gewährleisten. Andererseits verbessert eine möglichst geringe Breite des verbleibenden Stegmaterials zwischen dem ausgebildeten Stegloch und einem benachbarten Temperierkanal die Temperierung des durch das Stegloch strömenden Gases. Auch bezüglich der Breite der Temperierkanäle wird das Erreichen eines Optimums zwischen den Strömungsverhältnissen und Durchflussmengen einerseits und der erreichbaren Dichte von Steglöchern pro Flächeneinheit im Gasverteiler angestrebt. So bietet eine geringe Breite der Temperierkanäle in Verbindung mit einer geringen Breite der Stege die Möglichkeit, eine hohe Dichte von Steglöchern pro Flächeneinheit im Gasverteiler zu erreichen.

Die im erfindungsgemäßen Gasverteiler eingesetzten Platten können aus jedem geeigneten Material bestehen, das ein gasdichtes Verbinden der Platten miteinander mit einem Fügeverfahren, die Bearbeitung der Platten, insbesondere das Ausbilden der Stege der Temperierkanäle und ggf. der Gaszufuhrkanäle sowie der Löcher und Öffnungen, sowie eine gute Wärmeleitung und damit eine gute Temperierung der zu verteilenden Gase durch das Temperierfluid ermöglicht. Als Fügeverfahren kommen bspw. Löten (z.B. Vakuumhartlöten), Schweißen (z.B. Diffusionsschweißen) oder Kleben zum Einsatz. Ein weiteres Auswahlkriterium für das Plattenmaterial ist die Beständigkeit des Materials in der Einsatzumgebung des Gasverteilers, also bspw. gegenüber reaktiven Gasen, die in einer Bearbeitungskammer vorliegen. Solche Materialien können z.B. Metalle, wie bspw. Aluminium, Keramik, Quarz oder Graphit sowie Kombinationsmaterialien, wie bspw. Legierungen oder Verbundwerkstoffe, sein. Vorzugsweise bestehen die Bodenplatte, die Temperierplatte und die Deckplatte sowie ggf. auch die Abdeckplatte und die Gaszufuhrplatte aus demselben Material, insbesondere einem Metall. Damit ist zum einen die gasdichte Verbindung der Platten einfach realisierbar und zum anderen werden thermische Spannungen innerhalb des Gasverteilers, die aus dem Einsatz verschiedener Materialien resultieren können, vermieden. Auch der Temperierfluidzufuhraufsatz, der Temperierfluidauslassaufsatz sowie die Gaszufuhraufsätze bestehen vorzugsweise aus demselben Material.

Das erfindungsgemäße Verfahren zur Herstellung eines Gasverteilers umfasst die Schritte zum Bereitstellen der benötigten Platten und Aufsätze, insbesondere einer Bodenplatte, einer Temperierplatte und einer Deckplatte sowie mindestens eines Termperierfluidzufuhraufsatzes und mindestens eines Temperierfluidauslassaufsatzes, zum Ausbilden einer Mehrzahl von Temperierkanälen in der Temperierplatte, zum Ausbilden mindestens eines Temperierfluidverteilers und mindestens eines Temperierfluidsammlers in der Deckplatte, zum gasdichten Verbinden der Platten miteinander mittels eines Fügeverfahrens, zum gasdichten Verbinden des mindestens einen Temperierfluidzufuhraufsatzes und des mindestens einen Temperierfluidauslassaufsatzes mit der Deckplatte und zum Ausbilden von Öffnungen und Löchern in den einzelnen Platten, die gemeinsam Gaskanäle zum Durchtritt eines Gases durch den Gasverteiler bilden.

Die bereitgestellten Platten weisen denselben Umriss auf und sind vorzugsweise deckungsgleich. Die Temperierkanäle werden durch das Ausbilden von Durchbrüchen durch die Temperierplatte erzeugt, wobei die einzelnen Durchbrüche voneinander durch Stege getrennt sind. Die Temperierkanäle weisen erste Enden an einer ersten Seite der Temperierplatte und zweite Enden an einer zweiten Seite der Temperierplatte auf, reichen jedoch nicht vollständig bis zur jeweiligen Seite der Temperierplatte. Das heißt, dass die Temperierkanäle durch das Material der Temperierplatte von allen Außenkanten der Temperierplatte beabstandet sind. Die zweite Seite der Temperierplatte liegt der ersten Seite gegenüber. Der mindestens eine Temperierfluidverteiler und der mindestens eine Temperierfluidsammler werden als Durchbrüche durch die Deckplatte erzeugt. Beim gasdichten Verbinden der Platten werden diese derart verbunden, dass die Kanten der Platten übereinander liegen und der mindestens eine Temperierfluidverteiler die ersten Enden aller mit ihm korrespondierenden Temperierkanäle überdeckt und der mindestens eine Temperierfluidsammler die zweiten Enden aller mit ihm korrespondierenden Temperierkanäle überdeckt. Beim gasdichten Verbinden des mindestens einen Temperierfluidzufuhraufsatzes und des mindestens einen Temperierfluidauslassaufsatzes mit der Deckplatte werden diese derart angeordnet, dass ein spezifischer Temperierfluidzufuhraufsatz den mit ihm korrespondierenden Temperierfluidverteiler vollständig bedeckt und ein spezifischer Temperierfluidauslassaufsatz den mit ihm korrespondierenden Temperierfluidsammler vollständig bedeckt. Im Schritt zum Ausbilden von Gaskanälen werden Gaseinlassöffnungen in der Deckplatte, Steglöcher in den Stegen der Temperierplatte und Gasauslassöffnungen in der Bodenplatte in einem gemeinsamen Arbeitsgang erzeugt, wobei die Gaseinlassöffnungen die Deckplatte, die Steglöcher die Temperierplatte und die Gasauslassöffnungen die Bodenplatte vollständig durchdringen.

Da die Gaskanäle, also die Gaseinlassöffnungen in der Deckplatte, die Steglöcher in den Stegen der Temperierplatte und die Gasauslassöffnungen in der Bodenplatte, in einem gemeinsamen Arbeitsgang erzeugt werden, weisen die Gaskanäle in ihrem Verlauf keinen Versatz oder Knicke oder ähnliches auf und können insgesamt glatter und einfacher, bspw. ohne Justierung sehr kleiner Löcher in verschiedenen Platten zueinander, erzeugt werden. Auch können die Gaskanäle insgesamt sehr dünn ausgeführt werden, so dass eine hohe Dichte und Homogenität der Anordnung der Gaskanäle über den Gasverteiler hinweg erreicht werden kann. Bspw. können die ausgebildeten Gaskanäle einen Durchmesser von ca. 0,5 mm und eine Dichte von 10 bis 20 Kanälen/cm² aufweisen. Das Verfahren ermöglicht eine besonders einfache und kostengünstige Herstellung eines Gasverteilers.

In einer spezifischen Ausführungsform des Verfahrens, mit dem ein Gasverteiler zur Verteilung von zwei verschiedenen Gasen hergestellt wird, werden zusätzlich eine Abdeckplatte, eine Gaszufuhrplatte und ein erster Gaszufuhraufsatz bereitgestellt, wobei die Abdeckplatte und die Gaszufuhrplatte denselben Umriss wie die Bodenplatte, die Temperierplatte und die Deckplatte aufweisen und vorzugsweise deckungsgleich sind. Darüber hinaus wird in der Deckplatte neben dem mindestens einen Temperierfluidverteiler und dem mindestens einen Temperierfluidsammler zusätzlich eine erste Gaszufuhröffnung als Durchbruch durch die Deckplatte ausgebildet. Weiterhin werden in der Abdeckplatte mindestens ein Temperierfluidverteiler und mindestens ein Temperierfluidsammler durch das Ausbilden von Durchbrüchen durch die Abdeckplatte ausgebildet, die mit dem Temperierfluidverteiler und dem Temperierfluidsammler in der Deckplatte korrespondieren. Auch in der Gaszufuhrplatte werden mindestens ein Temperierfluidverteiler und mindestens ein Temperierfluidsammler ausgebildet, wobei der mindestens eine Temperierfluidverteiler und der mindestens eine Temperierfluidsammler mit dem mindestens einen Temperierfluidverteiler und dem mindestens einen Temperierfluidsammler in der Deckplatte korrespondieren und an einer ersten Seite bzw. einer zweiten Seite der Gaszufuhrplatte ausgebildet werden. Darüber hinaus wird in der Gaszufuhrplatte eine Mehrzahl von Gaszufuhrkanälen durch das Ausbilden von Durchbrüchen durch die Gaszufuhrplatte ausgebildet. Die einzelnen Gaszufuhrkanäle sind voneinander durch Stege getrennt und weisen erste Enden an einer dritten Seite der Gaszufuhrplatte und zweite Enden an einer vierten Seite der Gaszufuhrplatte auf. Die Gaszufuhrkanäle reichen jedoch nicht vollständig bis zur jeweiligen Seite, sondern sind durch das Material der Gaszufuhrplatte von den Außenkanten der Gaszufuhrplatte beabstandet. Die dritte Seite und die vierte Seite der Gaszufuhrplatte sind verschieden von der ersten und der zweiten Seite der Gaszufuhrplatte, wobei die vierte Seite der dritten Seite gegenüberliegt.

In dieser spezifischen Ausführungsform wird der Schritt zum gasdichten Verbinden der Platten miteinander erweitert und in einzelne Teilschritte aufgespalten. In einem ersten Teilschritt werden die Bodenplatte, die Temperierplatte und die Abdeckplatte mittels eines Fügeverfahrens gasdicht derart miteinander verbunden, dass die Kanten der Platten übereinander liegen und der mindestens eine Temperierfluidverteiler in der Abdeckplatte die ersten Enden aller mit ihm korrespondierenden Temperierkanäle überdeckt und der mindestens eine Temperierfluidsammler in der Abdeckplatte die zweiten Enden aller mit ihm korrespondierenden Temperierkanäle überdeckt. Im Ergebnis wird ein erster Plattenverbund erzeugt. In einem zweiten Teilschritt werden in der Abdeckplatte erste Gasdurchtrittslöcher, in den Stegen der Temperierplatte erste Steglöcher und in der Bodenplatte erste Gasauslassöffnungen in einem gemeinsamen Arbeitsgang ausgebildet, wobei die Gasdurchtrittslöcher die Abdeckplatte, die Steglöcher die Temperierplatte und die Gasauslassöffnungen die Bodenplatte vollständig durchdringen. Die dabei erzeugten ersten Gaskanäle dienen der Verteilung eines Gases, das während des Betriebes des Gasverteilers durch den Gaszufuhraufsatz, die erste Gaszufuhröffnung in der Deckplatte und die Gaszufuhrkanäle in der Gaszufuhrplatte bereitgestellt wird. In einem dritten Teilschritt werden der erste Platteverbund, die Gaszufuhrplatte und die Deckplatte miteinander mittels eines Fügeverfahrens derart gasdicht miteinander verbunden, dass die Kanten der Platten übereinander liegen und die Temperierfluidverteiler sowie die Temperierfluidsammler in der Gaszufuhrplatte und in der Deckplatte mit dem mindestens einen Temperierfluidverteiler und dem mindestens einen Temperierfluidsammler in der Abdeckplatte korrespondieren und die erste Gaszufuhröffnung in der Deckplatte die ersten Enden der Gaszufuhrkanäle vollständig überdeckt.

Zusätzlich zum gasdichten Verbinden des Temperierfluidzufuhraufsatzes und des Temperierfluidauslassaufsatzes mit der Deckplatte wird der erste Gaszufuhraufsatz gasdicht mit dem Deckplatte derart verbunden, dass der Gaszufuhraufsatz die Gaszufuhröffnung vollständig bedeckt. Des Weiteren werden in der Deckplatte die Gaseinlassöffnungen, in den Stegen der Gaszufuhrplatte Steglöcher sowie zweite Gasdurchtrittslöcher in der Abdeckplatte, zweite Steglöcher in den Stegen der Temperierplatte und zweite Gasauslassöffnungen in der Bodenplatte in einem gemeinsamen Arbeitsgang ausgebildet. Dabei durchdringen die Gaseinlassöffnungen die Deckplatte, die Steglöcher die Gaszufuhrplatte, die zweiten Steglöcher die Temperierplatte, die zweiten Gasdurchtrittslöcher die Abdeckplatte und die zweiten Gasauslassöffnungen die Bodenplatte vollständig. Die in diesem Schritt ausgebildeten zweiten Gaskanäle dienen der Verteilung eines Gases, das während des Betriebes des Gasverteilers oberhalb der Deckplatte bereitgestellt wird, so dass das Gas durch die Gaseinlassöffnungen in der Deckplatte, die Steglöcher in der Gaszufuhrplatte, die zweiten Gasdurchtrittslöcher in der Abdeckplatte, die zweiten Steglöcher in der Temperierplatte und die zweiten Gasauslassöffnungen in der Bodenplatte in einen Bearbeitungsraum unterhalb der Bodenplatte strömen kann.

Das Verfahren kann durch die Aufnahme weiterer Schritte bzw. das Ausbilden weiterer Öffnungen und das Bereitstellen weiterer Elemente des Gasverteilers erweitert und an den gewünschten, herzustellenden Gasverteiler angepasst werden, so dass bspw. Gasverteiler auch für mehr als zwei Gase, wie bereits mit Bezug auf den erfindungsgemäßen Gasverteiler beschrieben, hergestellt werden können.

Da die Gaskanäle, die einem spezifischen Gas zugeordnet sind, also die ersten Gasdurchtrittslöcher in der Abdeckplatte, die erste Steglöchern in den Stegen der Temperierplatte und die ersten Gasauslassöffnungen in der Bodenplatte bzw. die Gaseinlassöffnungen in der Deckplatte, die Steglöcher in den Stegen der Gaszufuhrplatte, die zweiten Gasdurchtrittslöcher in der Abdeckplatte, die zweiten Steglöcher in den Stegen der Temperierplatte und die zweiten Gasauslassöffnungen in der Bodenplatte, in einem gemeinsamen Arbeitsgang ausgebildet werden, weisen diese eine glatte Oberfläche auf und können auf einfache und kostengünstige Weise sehr klein und dicht angeordnet erzeugt werden.

Die Temperierkanäle und die Gaszufuhrkanäle sowie die Gaszufuhröffnung in der Deckplatte und die Temperierfluidverteiler und Temperierfluidsammler in den verschiedenen Platten können durch ein kostengünstiges Fertigungsverfahren, z.B. Laserschneiden, Wasserstrahlschneiden, Fräsen etc., ausgebildet werden. Die Erzeugung der Gaskanäle erfolgt mittels eines geeigneten Fertigungsverfahrens, wie bspw. Bohren, Drahterodieren, Laserschneiden, Wasserstrahlschneiden oder anderen bekannten Verfahren. Die einzelnen Platten werden miteinander z.B. durch Vakuumhartlöten, Diffusionsschweißen oder Kleben gasdicht verbunden. Dies stellt sicher, dass auch die Temperierplatte und ggf. die Gaszufuhrplatte gasdicht mit den angrenzenden Platten auch in den Bereichen der Stege verbunden sind. Auch die Aufsätze können mit einem solchen Verfahren mit der Deckplatte verbunden werden, jedoch sind auch andere Fügeverfahren möglich, solange diese eine gasdichte Verbindung gewährleisten.

Vorzugsweise wird nach dem Schritt zum gasdichten Verbinden der einzelnen Platten miteinander bzw. nach dem Erzeugen des ersten Plattenverbundes mittels eines Fügeverfahrens und vor dem Schritt zum Ausbilden von Öffnungen und Löchern in den Platten bzw. dem ersten Plattenverbund ein Schritt zum Überprüfen der Dichtheit des Gasverteilers gegenüber einem Temperierfluid, welches bei Benutzung des fertiggestellten Gasverteilers durch den bzw. die Temperierfluidverteiler in die ersten Enden der Temperierkanäle, durch die Temperierkanäle und aus den zweiten Enden der Temperierkanäle durch den bzw. die Temperierfluidsammler strömt, ausgeführt. Dazu kann ein Fluid, bspw. das Temperierfluid, in den ersten Plattenverbund eingeleitet werden, so dass das Fluid durch den bzw. die Temperierfluidverteiler in die ersten Enden der Temperierkanäle, durch die Temperierkanäle und aus den zweiten Enden der Temperierkanäle durch den bzw. die Temperierfluidsammler strömt. Selbstverständlich können auch andere Verfahren zur Dichtheitsprüfung bzw. zur Prüfung der Ausführung des Fügeschrittes genutzt werden. Damit kann bereits vor dem Ausbilden der Gaskanäle die Qualität des jeweiligen Fügeschrittes überprüft und der Fügeschritt ggf. erneut durchgeführt werden. Wird ein Gasverteiler zur Verteilung zweier verschiedener Gase hergestellt, so kann solch ein Schritt zum Überprüfen der Dichtheit des ersten Plattenverbundes erneut nach dem Schritt zum Ausbilden der ersten Gasdurchtrittslöcher in der Abdeckplatte, der ersten Steglöcher in den Stegen der Temperierplatte und der ersten Gasauslassöffnungen in der Bodenplatte ausgeführt werden, bevor der erste Plattenverbund, die Gaszufuhrplatte und die Deckplatte miteinander verbunden werden.

Vorzugsweise werden die Stege in der Temperierplatte so ausgebildet, dass sie in allen Bereichen dieselbe Dicke aufweisen wie die Temperierplatte.

Weiterhin vorzugsweise werden die Stege in der Temperierplatte so ausgebildet, dass sie in den Bereichen, in denen ein Stegloch ausgebildet wurde, eine größere Breite aufweisen als in anderen Bereichen.

Vorzugsweise werden die Stege in der Temperierplatte so ausgebildet, dass die Breite des Materials der Temperierplatte, das sich zwischen zwei benachbarten Temperierkanälen befindet, größer als oder gleich der Breite des Materials der Temperierplatte, das sich zwischen einem Temperierkanal und einem ausgebildeten Stegloch befindet, ist. Das heißt, nach dem Erzeugen der Steglöcher soll die Entfernung zwischen dem Rand eines Steglochs und dem Rand eines vom diesem Stegloch durch das Material der Temperierplatte beabstandeten Temperierkanals kleiner sein als die Entfernung zwischen zwei benachbarten Temperierkanälen, die durch einen Steg voneinander getrennt sind. Bei einer bekannten lateralen Ausdehnung der zu erzeugenden Steglöcher und einer angenommenen optimalen Anordnung des Steglochs mit Bezug auf die Breite des Steges, kann daher die Stegbreite beim Ausbilden der Temperierkanäle in der Temperierplatte so gewählt werden, dass sie in den Bereichen, in denen in einem späteren Verfahrensschritt die Steglöcher erzeugt werden, eine dieser Anforderung entsprechende Breite aufweisen.

Nachfolgend wird die Erfindung anhand der Figuren näher erläutert. Es zeigen:
- Fig. 1: eine schematische perspektive Darstellung eines Beispiels einer ersten Ausführungsform des erfindungsgemäßen Gasverteilers;
- Fig. 2: eine schematische perspektivische Darstellung der einzelnen Elemente des Gasverteilers aus Fig. 1;
- Fig. 3: eine schematische Draufsicht auf den Gasverteiler aus Fig. 1, in der die Anordnung der Elemente der einzelnen Platten zueinander verdeutlicht wird;
- Fig. 4: einen Querschnitt durch den Gasverteiler aus Fig. 1 entlang der Linie A-A';
- Fig. 5: eine schematische perspektive Darstellung eines Beispiels einer zweiten Ausführungsform des erfindungsgemäßen Gasverteilers;
- Fig. 6: eine schematische perspektivische Darstellung der einzelnen Elemente des Gasverteilers aus Fig. 5;
- Fig. 7: eine schematische Draufsicht auf den Gasverteiler aus Fig. 5, in der die Anordnung der Elemente der einzelnen Platten zueinander verdeutlicht wird;
- Fig. 8: einen Querschnitt durch den Gasverteiler aus Fig. 5 entlang der Linie B-B';
- Fig. 9: eine schematische perspektivische Darstellung der einzelnen Elemente eines Gasverteilers mit mehreren Temperierfluidzufuhraufsätzen und Temperierfluidverteilern;
- Fig. 10: einen Ausschnitt aus einer schematische Draufsicht auf eine Ausführungsform einer Temperierplatte des erfindungsgemäßen Gasverteilers;
- Fig. 11: eine schematische Darstellung einer ersten Ausführungsform des erfindungsgemäßen Verfahrens zur Herstellung eines Gasverteilers;
- Fig. 12: eine schematische Darstellung einer zweiten Ausführungsform des erfindungsgemäßen Verfahrens zur Herstellung eines Gasverteilers.

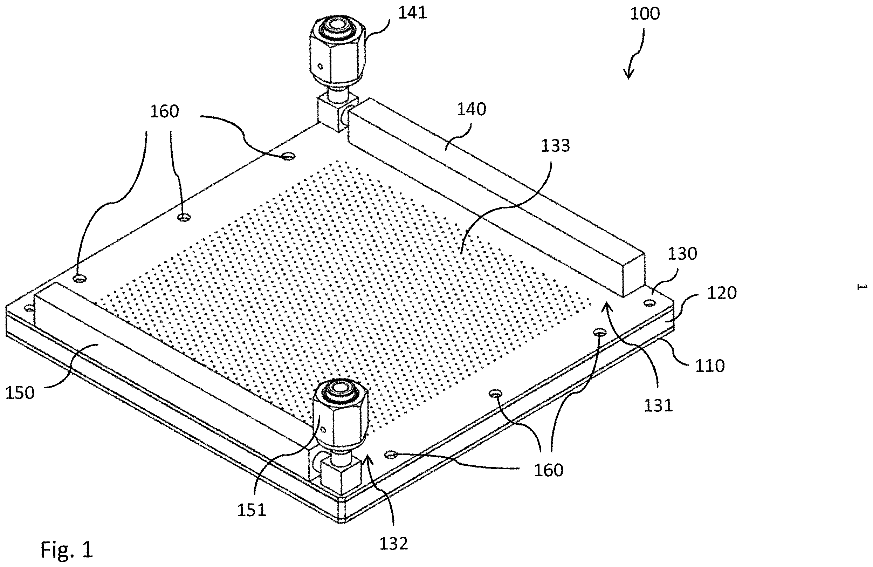

In **Figur 1** ist schematisch ein Beispiel 100 einer ersten Ausführungsform des erfindungsgemäßen Gasverteilers in einer perspektivischen Ansicht dargestellt. Die erste Ausführungsform des Gasverteilers ist geeignet, ein Gas aus einem Gasvorratsraum in einen Bearbeitungsraum einzuleiten und dabei über eine spezifische Fläche zu verteilen. Der Gasverteiler weist eine Bodenplatte 110, eine Temperierplatte 120 und eine Deckplatte 130 sowie einen Temperierfluidzufuhraufsatz 140 und einen Temperierfluidauslaussaufsatz 150 auf. Der Temperierfluidzufuhraufsatz 140 enthält einen Temperierfluidzufuhranschluss 141 und ist an einer ersten Seite 131 der Deckplatte 130 angeordnet und gasdicht mit der Deckplatte 130 verbunden. Der Temperierfluidauslassaufsatz 150 enthält einen Temperierfluidauslassanschluss 151 und ist an einer zweiten Seite 132 der Deckplatte 130 angeordnet und gasdicht mit der Deckplatte 130 verbunden, wobei die zweite Seite 132 der ersten Seite 131 gegenüberliegt. Die Bodenplatte 110, die Temperierplatte 120 und die Deckplatte 130 weisen dieselben Umrisse und dieselben Maße auf und sind deckungsgleich aufeinander angeordnet und miteinander gasdicht verbunden. Weiterhin sind in der Fig. 1 Gaseinlassöffnungen 133, die in der Deckplatte 130 ausgebildet sind, dargestellt. Die an den nicht von den Aufsätzen 140 und 150 überdeckten Seiten des Gasverteilers dargestellten Befestigungslöcher 160 dienen der Verbindung des Gasverteilers mit anderen Bauteilen, bspw. mit einem Gasvorratsbehälter oder einer Bearbeitungskammerwand.

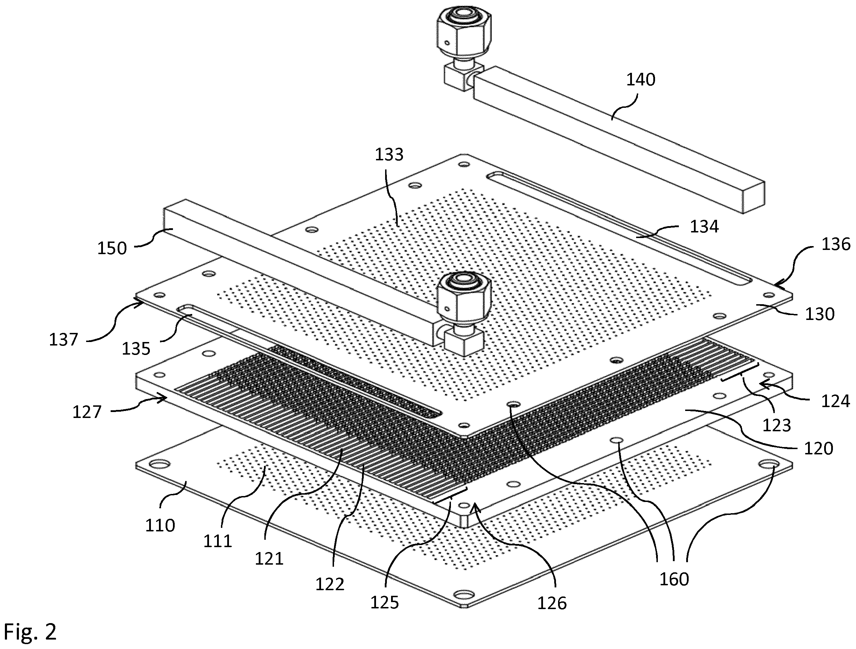

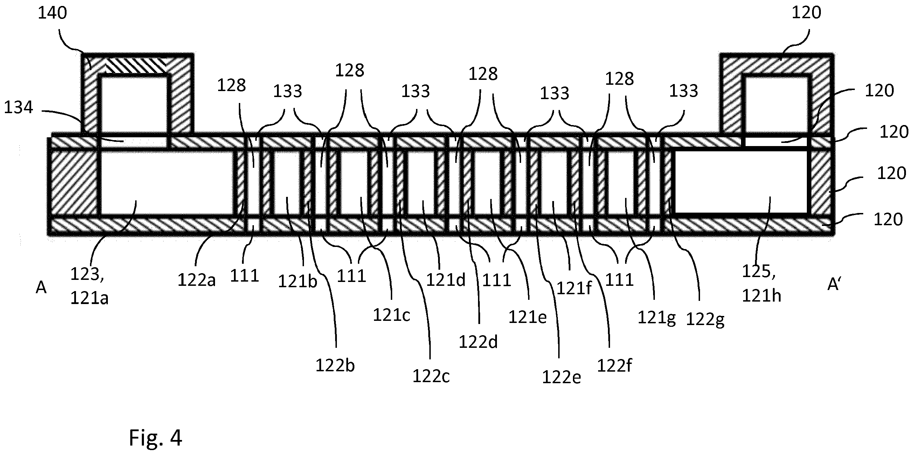

**Figur 2** zeigt die einzelnen Elemente des Gasverteilers aus Fig. 1 in einer perspektivischen, auseinander gezogenen Darstellung. Hierbei sind insbesondere ein Temperierfluidverteiler 134 in der Deckplatte 130, der an der ersten Seite 131 der Deckplatte 130 angeordnet und in Fig. 1 durch den Temperierfluidzufuhraufsatz 140 überdeckt ist, und ein Temperierfluidsammler 135, der an der zweiten Seite 132 der Deckplatte 130 angeordnet und in Fig. 1 durch den Temperierfluidauslassaufsatz 150 überdeckt ist, zu sehen. Der Temperierfluidverteiler 134 und der Temperierfluidsammler 135 sind Durchbrüche durch die Deckplatte 130 und sind von den jeweiligen Außenkanten 136 und 137 der Deckplatte 130 durch Material der Deckplatte 130 beabstandet. Darüber hinaus sind nunmehr Temperierkanäle 121 in der Temperierplatte 120 zu sehen. Die Temperierkanäle 121 sind durch Stege voneinander getrennt und weisen jeweils ein erstes Ende 123, das an einer ersten Seite 124 der Temperierplatte 120 angeordnet ist, und ein zweites Ende 125, das an einer zweiten Seite der Temperierplatter 120 angeordnet ist, auf. Damit erstrecken sich die Temperierkanäle 121 jeweils von ihrem ersten Ende 123 bis zu ihrem zweiten Ende 125, reichen jedoch nicht bis an die jeweilige Außenkante der Temperierplatte 120. Bspw. sind die zweiten Enden 125 durch Material der Temperierplatte 120 von der Außenkante 127 der Temperierplatte 120 an dessen zweiter Seite 126 beabstandet. In den Stegen ausgebildete Steglöcher sind in Fig. 2 aufgrund des Maßstabs nicht zu erkennen, werden aber mit Bezug auf Fig. 4 noch erläutert. Darüber hinaus sind Gasauslassöffnung 111 in der Bodenplatte 110 zu sehen, die als Durchbrüche durch die Bodenplatte 110 ausgebildet sind. Jede Gaseinlassöffnung 133 korrespondiert mit einem Stegloch in der Temperierplatte und mit einer Gasauslassöffnung 111, gemeinsam bilden sie einen Gaskanal. Ebenfalls in Fig. 1 ist zu sehen, dass die Befestigungslöcher 160 nicht nur in der Deckplatte 130 sondern auch in der Temperierplatte 120 und in der Bodenplatte 110 ausgebildet sind, wobei jeweils ein Befestigungsloch 160 in der Bodenplatte 110 mit einem darüber liegenden Befestigungsloch 160 in der Temperierplatte 120 und einem darüber liegenden Befestigungsloch 160 in der Deckplatte 130 korrespondiert. Durch den so entstandenen Befestigungskanal kann eine Schraube oder ein Niet oder ein anderes Befestigungsmittel durchgeführt werden. Möglich ist jedoch auch, dass die Befestigungslöcher 160 nur in der Deckplatte 130 oder in der Deckplatte 130 und in der Temperierplatte 120 ausgebildet sind und jeweils ein Innengewinde aufweisen, so dass eine Schraube als Befestigungsmittel genutzt werden kann.

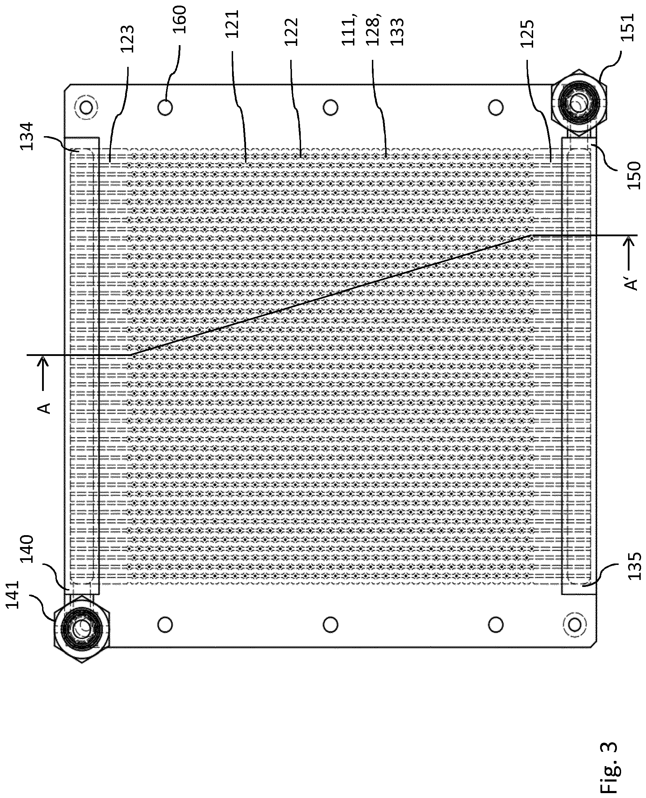

In **Figur 3** ist eine schematische Draufsicht auf den Gasverteiler aus Fig. 1 gezeigt, wobei die Elemente der einzelnen Platten und ihre Anordnung zueinander sichtbar gemacht wurden. Zu sehen sind insbesondere die Temperierkanäle 121, die durch Stege 122 voneinander getrennt sind, und die Gasauslassöffnungen 111, Steglöcher 128, die in den Stegen 122 der Temperierplatte 120 ausgebildet sind, und die Gaseinlassöffnungen 133, wobei jeweils eine Gasauslassöffnung 111, ein Stegloch 128 und eine Gaseinlassöffnung 133 genau übereinander liegen und daher nur als ein Loch in der Darstellung der Figur 3 erscheinen. Darüber hinaus sind die ersten Enden 123 der Temperierkanäle 121 sowie der darüber angeordnete Temperierfluidverteiler 134 und der darüber angeordnete Temperierfluidzufuhraufsatz 140 mit dem Temperierfluidzufuhranschluss 141 einerseits und die zweiten Enden 125 der Temperierkanäle 121 sowie der darüber angeordnete Temperierfluidsammler 135 und der darüber angeordnete Temperierfluidauslassaufsatz 150 mit dem Temperierfluidauslassanschluss 151 andererseits zu sehen.

**Figur 4** zeigt den Blick auf einen Querschnitt durch den Gasverteiler aus Fig. 1 entlang der in Fig. 3 eingezeichneten Linie A-A'. Der Linie A-A' verläuft zunächst entlang eines Tempierkanals 121a, kreuzt danach mehrere Stege 122a bis 122g jeweils in einem Bereich, in dem ein Stegloch 128 ausgebildet ist, und mehrere Temperierkanäle 122b bis 121g und verläuft zum Schluss wieder entlang eines anderen Temperierkanals 121h. Zu sehen sind wiederum die Bodenplatte 110 mit den Gasauslassöffnungen 111, die Temperierplatte 120 mit Temperierkanälen 121a bis 121h und Stegen 122a bis 122g sowie die Deckplatte 130 mit den Gaseinlassöffnungen 133, dem Temperierfluidverteiler 134 und dem Temperierfluidsammler 135. Ebenfalls zu sehen ist das erste Ende 123 des Temperierkanals 121a, durch den die Schnittlinie zunächst verläuft, sowie das zweite Ende 125 des Temperierkanals 121h, durch den die Schnittlinie zum Schluss verläuft. Darüber hinaus sind der Temperierfluidzufuhraufsatz 140 und der Temperierfluidauslassaufsatz 150 dargestellt. Ein Gas kann damit aus einem Gasvorratsbehälter, der oberhalb der Deckplatte 130 angeordnet und gasdicht mit der Deckplatte 130 verbunden ist, durch die Gaseinlassöffnungen 133, die jeweils korrespondierenden Steglöcher 128 und Gasauslassöffnungen 111 in einen Bearbeitungsraum unterhalb der Bodenplatte 110 strömen und dabei gleichmäßig und fein verteilt werden.

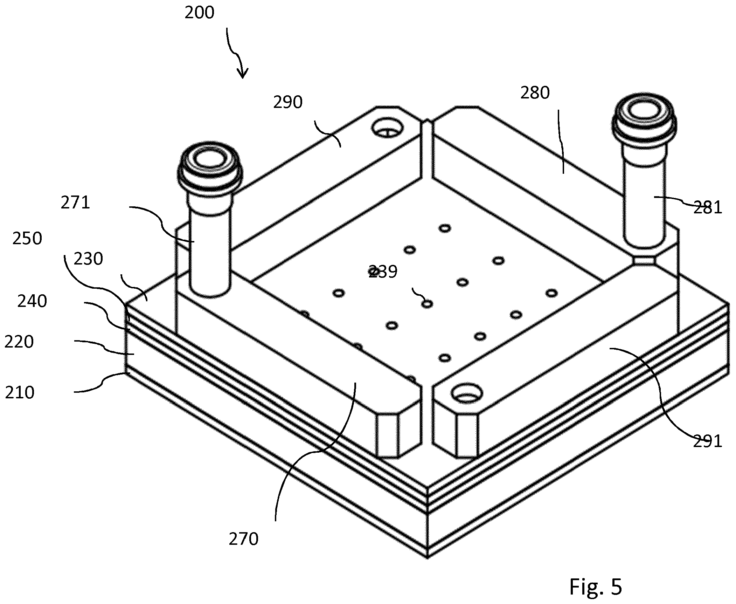

In **Figur 5** ist ein Beispiel 200 einer zweiten Ausführungsform des erfindungsgemäßen Gasverteilers in einer schematischen perspektivischen Ansicht dargestellt. Dieses Beispiel der zweiten Ausführungsform ermöglicht das Einleiten und Verteilen von zwei verschiedenen Gasen mit dem Gasverteiler. Dazu weist der Gasverteiler neben einer Bodenplatte 210, einer Temperierplatte 220 und einer Deckplatte 230 noch eine Abdeckplatte 240 und eine Gaszufuhrplatte 250 auf, die jeweils mit einer benachbarten Platte gasdicht verbunden sind. Zusätzlich zu einem Temperierfluidzufuhraufsatz 270 und einem Temperierfluidauslassaufsatz 280 sind noch ein erster Gaszufuhraufsatz 290 und ein zweiter Gaszufuhraufsatz 291 auf der Deckplatte 230 angeordnet und gasdicht mit dieser verbunden. Die Deckplatte 230 weist wieder Gaseinlassöffnungen 239 auf. Der Temperierfluidzufuhraufsatz 270 enthält einen Temperierfluidzufuhranschluss 271 und der Temperierfluidauslassaufsatz 280 enthält einen Temperierfluidauslassanschluss 281.

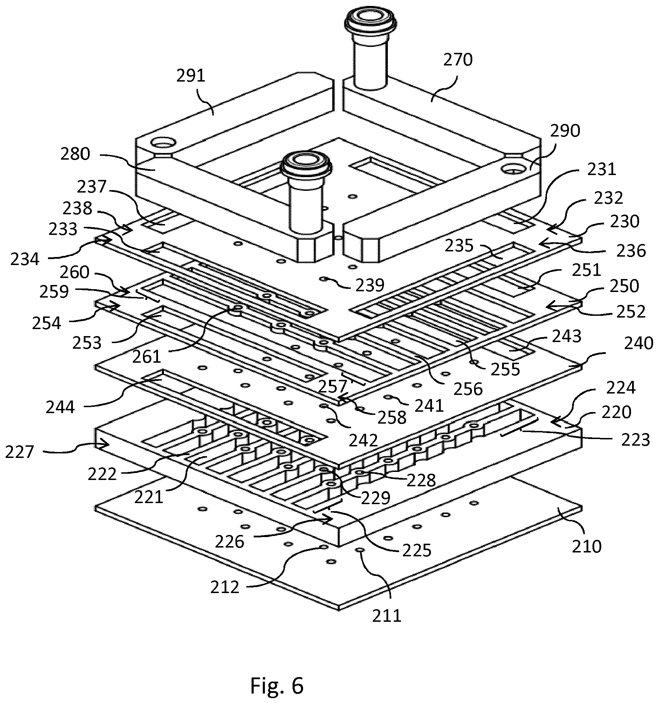

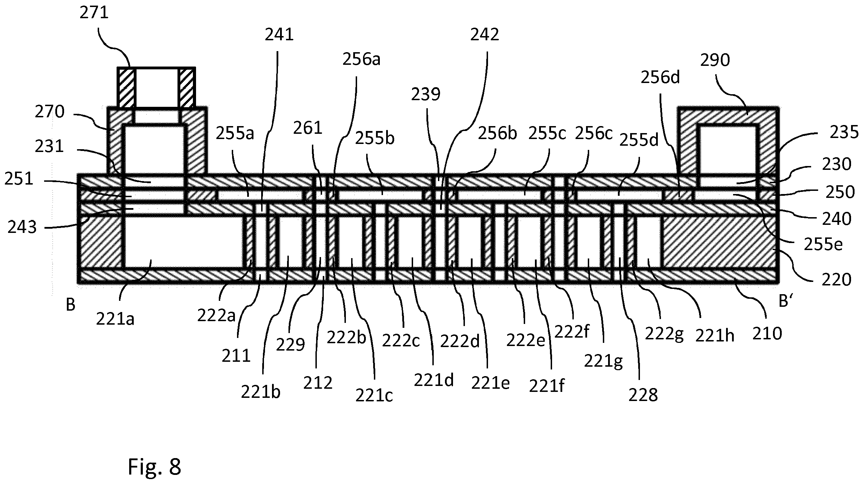

**Figur 6** zeigt die einzelnen Komponenten des Gasverteilers aus Fig. 5 in einer perspektivischen, auseinander gezogenen Darstellung, die nicht die wirklichen Größenverhältnisse der Elemente des Gasverteilers widerspiegelt. Dabei ist der Gasverteiler gegenüber der Ansicht in Fig. 5 um 90° um eine gedachte Rotationsachse, welche von oben nach unten durch den Gasverteiler verläuft, gedreht. Die Bodenplatte 210 weist erste Gasauslassöffnungen 211 und zweite Gasausauslassöffnungen 212 auf, die verschiedenen Gasen zugeordnet sind. Dies wird später mit Bezug auf die Fig. 8 näher erläutert. In der Temperierplatte 220 sind wieder Temperierkanäle 221 ausgebildet, die durch Stege 222 voneinander getrennt sind. Dabei weist jeder Temperierkanal 221 ein erstes Ende 223 an einer ersten Seite 234 der Temperierplatte 220 und ein zweites Ende 225 an einer zweiten Seite 236 der Temperierplatte 220 auf. Die Temperierkanäle 221 reichen dabei nicht an die Außenkanten der Temperierplatte 220 heran, wie dies beispielhaft für die Außenkante 227 gezeigt ist. In den Stegen 222 sind erste Steglöcher 228, die jeweils zu einer der ersten Gasauslassöffnungen 211 korrespondieren, und zweite Steglöcher 229, die jeweils zu einer der zweiten Gasauslassöffnungen 212 korrespondieren, ausgebildet. In der Abdeckplatte 240 sind erste Gasdurchtrittslöcher 241, die jeweils zu einer der ersten Gasauslassöffnungen 211 korrespondieren, und zweite Gasdurchtrittslöcher 242, die jeweils zu einer der zweiten Gasauslassöffnungen 212 korrespondieren, ausgebildet. Darüber hinaus weist die Abdeckplatte 240 einen Temperierfluidverteiler 243, der die ersten Enden 223 der Temperierkanäle 221 überdeckt, und einen Temperierfluidsammler 244, der die zweiten Enden 225 der Temperierkanäle 221 überdeckt, auf. In der Gaszufuhrplatte 250 sind ein Temperierfluidverteiler 251, der mit dem Temperierfluidverteiler 243 in der Abdeckplatte 240 korrespondiert, und ein Temperierfluidsammler 253, der mit dem Temperierfluidsammler 244 in der Abdeckplatte 240 korrespondiert, ausgebildet. Dabei ist der Temperierfluidverteiler 251 an einer ersten Seite 252 der Gazufuhrplatte 250 ausgebildet, während der Temperierfluidsammler 253 an einer zweiten Seite 254 der Gaszufuhrplatte 250 ausgebildet ist. Die Gaszufuhrplatte 250 weist weiterhin Gaszufuhrkanäle 255 auf, die durch Stege 256 voneinander getrennt sind. Dabei weist jeder Gaszufuhrkanal 255 ein erstes Ende 257 an einer dritten Seite 258 der Gaszufuhrplatte 250 und ein zweites Ende 259 an einer vierten Seite 260 der Gaszufuhrplatte 250 auf. Unter einer Seite ist hierbei jeweils ein Randbereich der Platte angrenzend an eine Außenkante der Platte zu verstehen, wobei sich die Seiten an den Ecken der Platte überlagern. Da die Platten einen nahezu viereckigen Umriss aufweisen, gibt es somit vier Seiten, wobei sich die erste und die zweite Seite und die dritte und die vierte Seite gegenüber liegen. In den Stegen 256 sind Steglöcher 261 ausgebildet, die mit den zweiten Gasauslassöffnungen 212 in der Bodenplatte 210, den zweiten Steglöchern 229 in der Temperierplatte 230 und den zweiten Gasdurchtrittslöchern 242 in der Abdeckplatte 240 korrespondieren. Die Gaszufuhrkanäle 255 überdecken die ersten Gasdurchtrittslöcher 241 in der Abdeckplatte 240, die mit den ersten Steglöchern 228 in der Temperierplatte 220 und den ersten Gasauslassöffnungen 211 in der Bodenplatte 210 korrespondieren. In der Deckplatte 230 sind ein Temperierfluidverteiler 231, der an der ersten Seite 232 der Deckplatte 230 angeordnet und in Fig. 1 durch den Temperierfluidzufuhraufsatz 270 überdeckt ist, und ein Temperierfluidsammler 233, der an der zweiten Seite 234 der Deckplatte 230 angeordnet und in Fig. 1 durch den Temperierfluidauslassaufsatz 280 überdeckt ist, zu sehen. Der Temperierfluidverteiler 231 korrespondiert mit dem Temperierfluidverteiler 251 in der Gaszufuhrplatte 250 und dem Temperierfluidverteiler 243 in der Abdeckplatte 240, während der Temperierfluidsammler 233 mit dem Temperierfluidsammler 253 in der Gaszufuhrplatte 250 und dem Temperierfluidsammler 244 in der Abdeckplatte 240 korrespondiert. Weiterhin sind eine erste Gaszufuhröffnung 235, die an einer dritten Seite 236 der Deckplatte 230 angeordnet und in Fig. 1 durch den ersten Gaszufuhraufsatz 290 überdeckt ist, und eine zweite Gaszufuhröffnung 237, die an einer vierten Seite 238 der Deckplatte 230 angeordnet und in Fig. 1 durch den zweiten Gaszufuhraufsatz 291 überdeckt ist, zu sehen. Die erste Gaszufuhröffnung 235 überdeckt die ersten Enden 257 der Gaszufuhrkanäle 255, während die zweite Gaszufuhröffnung 237 die zweiten Enden 259 der Gaszufuhrkanäle 255 überdeckt. Die Gaseinlassöffnungen 239 in der Deckplatte 230 korrespondieren mit den zweiten Gasauslassöffnungen 212 in der Bodenplatte.

Die Temperierfluidverteiler 243, 251 und 231 sowie die Temperierfluidsammler 244, 253 und 233 sind ebenso wie die Temperierkanäle 221, die Gaszufuhrkanäle 255 und die erste und die zweite Gaszufuhröffnungen 235, 237 Durchbrüche durch die jeweilige Platte und sind von den jeweiligen Außenkanten durch Material der jeweiligen Platte beabstandet. Damit erstrecken sich die Temperierkanäle 221 jeweils von ihrem ersten Ende 223 bis zu ihrem zweiten Ende 225, reichen jedoch nicht bis an die jeweilige Außenkante der Temperierplatte 220. In gleicher Weise erstrecken sich die Gaszufuhrkanäle 255 jeweils von ihrem ersten Ende 257 bis zu ihrem zweiten Ende 259, reichen jedoch nicht bis an die jeweilige Außenkante der Gaszufuhrplatte 250.

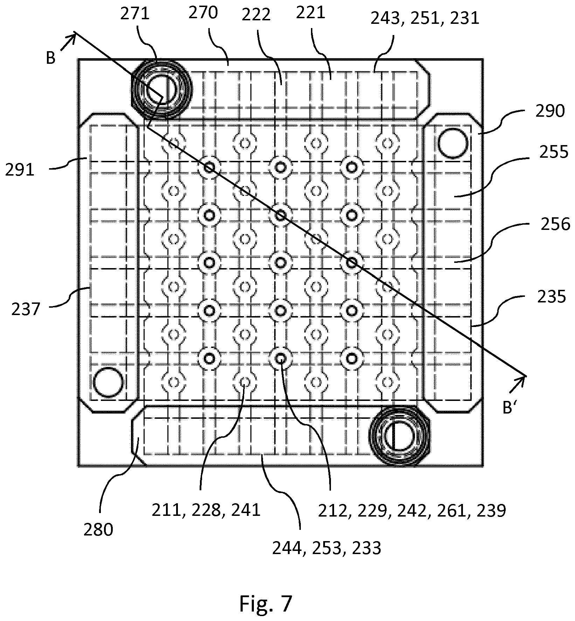

In **Figur 7** ist eine schematische Draufsicht auf den Gasverteiler aus Fig. 5 gezeigt, wobei die Elemente der einzelnen Platten und ihre Anordnung zueinander sichtbar gemacht wurden. Zu sehen sind insbesondere die Temperierkanäle 221, die durch Stege 222 voneinander getrennt sind, und die Gaszufuhrkanäle 255, die durch Stege 256 voneinander getrennt sind. Des Weiteren sind die ersten Gasauslassöffnungen 211, die ersten Steglöcher 228 in der Temperierplatte 220 und die ersten Gasdurchtrittslöcher 241 zu sehen, wobei jeweils eine erste Gasauslassöffnung 211, ein erstes Stegloch 228 und ein erstes Gasdurchtrittsloch 241 genau übereinander liegen und daher nur als ein Loch in der Darstellung der Figur 7 erscheinen. Auch die jeweils übereinanderliegenden zweiten Gasauslassöffnungen 212, zweiten Steglöcher 229, zweiten Gasdurchtrittslöcher 242, die Steglöcher 261 in der Gaszufuhrplatte 250 und die Gaseinlassöffnungen 239 erscheinen in Fig. 7 nur als ein Loch.

Darüber hinaus sind die Temperierfluidverteiler 243, 251 und 231 und der darüber angeordnete Temperierfluidzufuhraufsatz 270, die über den ersten Enden 223 der Temperierkanäle 221 angeordnet sind, sowie die Temperierfluidsammler 244, 253 und 233 und der darüber angeordnete Temperierfluidauslassaufsatz 280, die über den zweiten Enden 225 der Temperierkanäle 221 angeordnet sind, zu sehen. Auch der erste Gaszufuhraufsatz 290 und die erste Gaszufuhröffnung 235, die über den ersten Enden 257 der Gaszufuhrkanäle 255 angeordnet sind, und der zweite Gaszufuhraufsatz 291 und die zweite Gaszufuhröffnung 237, die über den zweiten Enden 259 der Gaszufuhrkanäle 255 angeordnet sind, sind dargestellt.

**Figur 8** zeigt den Blick auf einen Querschnitt durch den Gasverteiler aus Fig. 5 entlang der in Fig. 7 eingezeichneten Linie B-B'. Die Linie B-B"schneidet zunächst den Temperierfluidzufuhranschluss 271, knickt dann innerhalb des Temperierfluidzufuhranschlusses 271 um 90° ab, erstreckt sich bis zu einem Temperierkanal 221a, knickt dort wiederum um 90° ab und verläuft anschließend parallel zum ersten Teilstück der Linie weiter. Dabei kreuzt die Schnittlinie mehrere Temperierkanäle 221a bis 221h und Stege 222a bis 222g in der Temperierplatte 220 jeweils in einem Bereich, in dem ein erstes Stegloch 228 oder ein zweites Stegloch 229 ausgebildet ist, und mehrere Gaszufuhrkanäle 255a bis 255e und Stege 256a bis 256c in der Gaszufuhrplatte 250 jeweils in einem Bereich, in dem ein Stegloch 261 ausgebildet ist, und schneidet zum Schluss einen Steg 256d und einen Gaszufuhrkanal 255e im Bereich seines ersten Endes 257. Zu sehen sind wiederum die Bodenplatte 210 mit den ersten Gasauslassöffnungen 211 und den zweiten Gasauslassöffnungen 212, die Temperierplatte 220 mit Temperierkanälen 221a bis 221h, Stegen 222a bis 222g und ersten und zweiten Steglöchern 228, 229, die Abdeckplatte 240 mit den ersten Gasdurchtrittslöchern 241 und den zweiten Gasdurchtrittslöchern 242 sowie dem Temperierfluidverteiler 243, die Gaszufuhrplatte 250 mit den Gaszufuhrkanälen 255a bis 255e, den Stegen 256a bis 256d und den Steglöchern 261 sowie dem Temperierfluidverteiler 251 sowie die Deckplatte 230 mit den Gaseinlassöffnungen 239, dem Temperierfluidverteiler 231 und der ersten Gaszufuhröffnung 235. Darüber hinaus sind der Temperierfluidzufuhraufsatz 270 mit dem Temperierfluidzufuhranschluss 271 und der erste Gaszufuhraufsatz 290 dargestellt. Ein erstes Gas kann damit aus einem ersten Gasvorratsbehälter, der oberhalb des ersten Gaszufuhraufsatzes 290 und des zweiten Gaszufuhraufsatzes 291 angeordnet und mit diesen gasdicht verbunden ist, durch die erste Gaszufuhröffnung 235 und die zweite Gaszufuhröffnung 237 (in Fig. 8 nicht dargestellt) in die Gaszufuhrkanäle 255 und aus diesen durch die ersten Gasdurchtrittslöcher 241, die ersten Steglöcher 228 in der Temperierplatte 220 und die ersten Gasauslassöffnungen 211 in einen Bearbeitungsraum unterhalb der Bodenplatte 210 strömen und dabei gleichmäßig und fein verteilt werden. Ein zweites Gas kann aus einem zweiten Gasvorratsbehälter, der oberhalb der Deckplatte 230 angeordnet und gasdicht mit der Deckplatte 230 verbunden ist, durch die Gaseinlassöffnungen 239, die jeweils korrespondierenden Steglöcher 261 in der Gaszufuhrplatte 250, die zweiten Gasdurchtrittslöcher 242, die zweiten Steglöcher 229 in der Temperierplatte 220 und die zweiten Gasauslassöffnungen 212 in den Bearbeitungsraum strömen und dabei gleichmäßig und fein verteilt werden. Damit sind zwei Arten von Gaskanälen vorhanden, durch die unterschiedliche Gase hindurchtreten können.

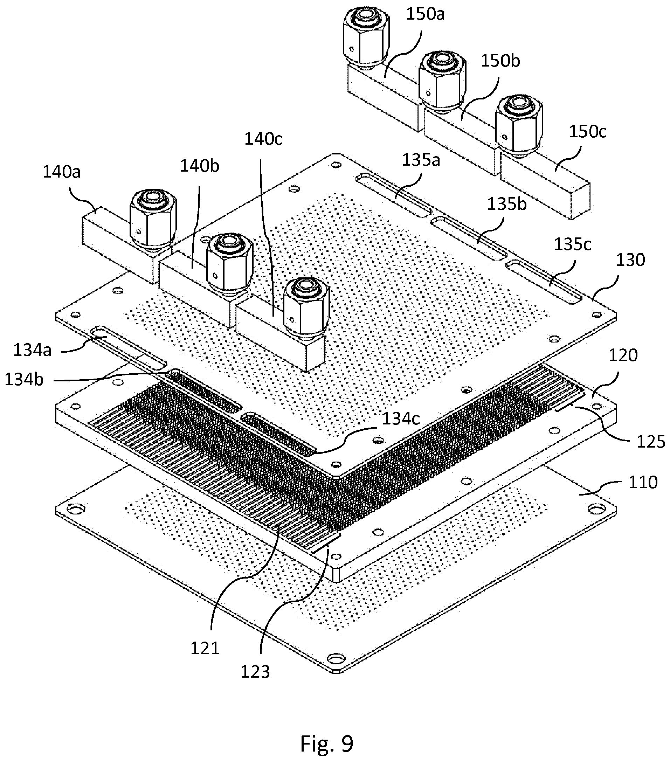

Ein Gasverteiler der ersten Ausführungsform oder der zweiten Ausführungsform kann auch mehrerer Temperierfluidzufuhraufsätze und mehrere Temperierfluidauslassaufsätze sowie entsprechend viele Temperierfluidverteiler und Temperierfluidsammler aufweisen. In **Fig. 9** ist ein Beispiel für einen Gasverteiler der ersten Ausführungsform mit drei Temperierfluidzufuhraufsätzen 140a, 140b und 140c, drei Temperierfluidauslassaufsätzen 150a, 150b und 150c sowie drei Temperierfluidverteilern 134a, 134b und 134c und drei Temperierfluidsammlern 135a, 135b und 135c in der Deckplatte 130 dargestellt. Dabei überdeckt der Temperierfluidverteiler 134a eine erste Anzahl von ersten Enden 123 der Temperierkanäle 121, der Temperierfluidverteiler 134b eine zweite Anzahl von ersten Enden 123 der Temperierkanäle 121 und der Temperierfluidverteiler 134c eine dritte Anzahl von ersten Enden 123 der Temperierkanäle 121, wobei jeder Temperierfluidverteiler 134a bis 134c verschiedene Temperierkanäle 121 überdeckt. Die erste, zweite und dritte Anzahl können verschieden oder zumindest teilweise gleich groß sein. Im dargestellten Fall, sind die erste, die zweite und die dritte Anzahl gleich. Jedoch kann bspw. auch die erste Anzahl und die dritte Anzahl gleich sein, während die zweite Anzahl größer als die erste Anzahl ist. Jeder Temperierfluidzufuhraufsatz 140a bis 140c korrespondiert mit einem spezifischen Temperierfluidverteiler 134a bis 134c. So korrespondiert der Temperierfluidzufuhraufsatz 140a mit dem Tempierfluidverteiler 134a, der Temperierfluidzufuhraufsatz 140b mit dem Temperierfluidverteiler 134b und der Temperierfluidzufuhraufsatz 140c mit dem Temperierfluidverteiler 134c. Die Temperierfluidauslassaufsätze 150a bis 150c korrespondieren mit einem spezifischen Temperierfluidsammler 135a bis 135c. So korrespondiert der Temperierfluidauslassaufsatz 150a mit dem Tempierfluidsammler 135a, der Temperierfluidauslassaufsatz 150b mit dem Temperierfluidsammler 135b und der Temperierfluidauslassaufsatz 150c mit dem Temperierfluidsammler 135c. Dabei überdeckt der Temperierfluidsammler 135a eine erste Anzahl von zweiten Enden 125 der Temperierkanäle 121, der Temperierfluidsammler 135b eine zweite Anzahl von zweiten Enden 125 der Temperierkanäle 121 und der Temperierfluidsammler 135c eine dritte Anzahl von zweiten Enden 125 der Temperierkanäle 121, wobei jeder Temperierfluidsammler 135a bis 135c verschiedene Temperierkanäle 121 überdeckt. Bezüglich der überdeckten Anzahlen von zweiten Enden 125 der Temperierkanäle gilt dasselbe wie mit Bezug auf die Anzahlen der ersten Enden 123 der Temperierkanäle, die von den Temperierfluidverteilern 134a bis 134c überdeckt werden. Vorzugsweise überdeckt ein spezifischer der Temperierfluidsammler 150a bis 150c die zweiten Enden 125 genau derjenigen Temperierkanäle 121, deren ersten Enden von einem spezifischen der Temperierfluidverteiler 134a bis 134c überdeckt werden.

Alternativ kann auch nur ein Temperierfluidauslassaufsatz 150 und ein Temperierfluidsammler 135, wie mit Bezug auf Fig. 1 beschrieben, ausgebildet sein. In jedem Fall kann damit in die erste Anzahl von ersten Enden 123 der Temperierkanäle 121 bspw. ein Temperierfluid mit einer ersten Temperatur über den Temperierfluidzufuhraufsatz 140a und den Temperierfluidverteiler 134a eingeleitet werden, während in die zweite Anzahl und die dritte Anzahl von ersten Enden 123 der Temperierkanäle 121 bspw. Temperierfluide mit anderen Temperaturen über die miteinander korrespondierenden Temperierfluidzufuhraufsätze 140b, 140c und Temperierfluidverteiler 134b, 134c eingeleitet werden können. Somit kann die Temperatur des jeweiligen Temperierfluids genau an die Temperierung, die an einem spezifischen Ort innerhalb des Gasverteilers erreicht werden soll, angepasst werden. Insbesondere kann somit eine homogenere Temperierung des Gasverteilers erreicht und/oder äußere Einflüsse, bspw. durch eine verstärkte Wärmeabgabe des Gasverteilers in seinen lateralen Randbereichen, ausgeglichen werden.

Obwohl in den Figuren gleichmäßige Anordnungen und Verteilungen der Gaskanäle dargestellt sind, ist jede geeignete Anordnung oder Verteilung der Gaskanäle, auch für verschiedene Gase wie in den Fig. 5 bis 9 dargestellt, herstellbar, wenn die Anordnung der Temperierkanäle und Gaszufuhrkanäle entsprechend gestaltet ist. Darüber hinaus können die Löcher und Öffnungen beliebige und untereinander verschiedene Formen, bspw. rund, oval, vier- oder mehreckig, und Größen aufweisen, solange der Durchtritt des oder der Gase sowie des Temperierfluids gewährleistet ist.

Beispielhaft seien die in Tabelle 1 aufgeführten Größen für die einzelnen Komponenten genannt, jedoch ist der erfindungsgemäße Gasverteiler nicht auf eine bestimmte Größe festgelegt. Die Länge und Breite sowie die Dicke bilden ein kartesisches System, wobei jedoch die Platten nicht rechtwinklig sein müssen, sondern beliebige Formen annehmen können. Vorzugsweise sind sie jedoch rechtwinklig. Bei den Temperierkanälen und den Gaszufuhrkanälen sowie den dazugehörigen Stegen ist die Länge die Ausdehnung, die zwischen den ersten und den zweiten Enden eines jeweiligen Kanals vorliegt, wobei die jeweiligen Enden eingeschlossen sind. Bei dem Temperierfluidverteiler, dem Temperierfluidsammler und der Gaszufuhröffnung ist die Länge die Ausdehnung, die quer zu den Enden der jeweiligen Temperier- oder Gaszufuhrkanäle, die von dem Element überdeckt werden, vorliegt.

**Tabelle 1**

| Element | Länge (in mm) | Breite (in mm) | Dicke (in mm) | Durchmesser (in mm) |
|---|---|---|---|---|
| Bodenplatte | 330 | 330 | 2 | |
| Temperierplatte | 330 | 330 | 8 | |
| Deckplatte | 330 | 330 | 2 | |
| Abdeckplatte | 330 | 330 | 2 | |
| Gaszufuhrplatte | 330 | 330 | 2 | |
| Temperierkanal | 325 | 2 | 8 | |
| Steg in der Temperierplatte | 325 | 1 | 8 | |
| Gaszufuhrkanal | 325 | 3 | 2 | |
| Steg in der Gaszufuhrplatte | 325 | 1 | 2 | |
| Gaseinlassöffnung, Gasauslassöffnung, Gasdurchtrittsloch, Stegloch | | | | 0,5 |
| Temperierfluidverteiler, Temperierfluidsammler | 325 | 10 | | |
| Gaszufuhröffnung | 280 | 10 | | |

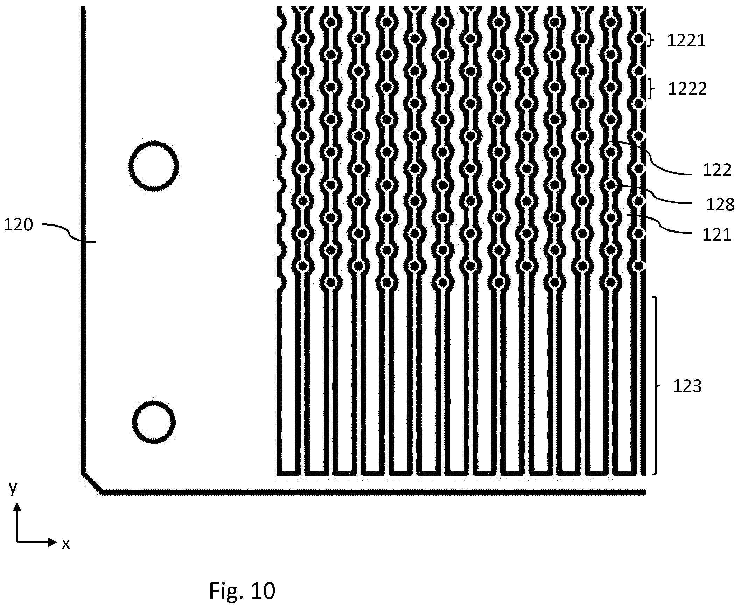

In **Figur 10** ist ein Ausschnitt auf eine schematische Draufsicht auf eine Temperierplatte 120 des Gasverteilers zu sehen. Dargestellt ist ein Abschnitt der Temperierplatte 120 mit Temperierkanälen 121, Stegen 122 und ersten Enden der Temperierkanäle 123. Die Stege und Temperierkanäle weisen eine Breite, die in x-Richtung gemessen wird, und eine Länge auf, die in y-Richtung gemessen wird, wobei die Temperierkanäle und Stege nicht über ihre volle Länge in Fig. 10 dargestellt sind. Die Stege 122 enthalten erste Bereiche 1221, in denen Steglöcher 128 ausgebildet sind, die in der Fig. 10 als schwarze Kreise dargestellt sind. Die ersten Bereiche 1221 weisen eine größere Breite auf, als zweite Stegbereiche 1222, in denen keine Steglöcher 128 ausgebildet sind. Damit bilden die Temperierkanäle 121 "Schlängellinien", in denen ein Temperierfluid die ersten Bereiche 1221 und das durch die Steglöcher 128 strömende Gas besonders gut temperieren kann. Die ersten Bereiche 1221 benachbarter Stege 122 sind entlang der y-Richtung versetzt zueinander angeordnet, wodurch eine große Dichte der ersten Bereiche 1221 und der Steglöcher 128 auf einer gegebenen Fläche realisiert werden kann. Gleichzeitig ist die Breite des Stegmaterials zwischen zwei benachbarten Temperierkanälen 121, d.h. in einem zweiten Bereich 1222, größer als die Breite des Stegmaterials zwischen einem Temperierkanal 121 und einem Stegloch 128 in einem ersten Bereich 1221. Damit kann das durch das Stegloch 128 strömende Gas besonders effektiv durch das Temperierfluid temperiert werden. Darüber hinaus verlaufen die Temperierkanäle 121 geradlinig, d.h. ohne Kehren, Knicke oder Kurven (außer um die ersten Bereiche 1221 der Stege 122 herum), entlang der y-Richtung, so dass eine großer Durchsatz des Temperierfluids und einheitliche Stömungverhältnisse über alle Temperierkanäle und über deren gesamte Länge hinweg erreichbar sind.

Die gleichen Ausgestaltungen und Aussagen, die mit Bezug auf die Temperierplatte 120 in Fig. 10 gemacht wurden, sind auch für die Temperierplatte 220 gültig. Auch die Gazufuhrkanäle 255 und Stege 256 in der Gaszufuhrplatte 250 können gleichartig ausgebildet sein, wobei erste Bereiche der Stege 256, in denen ein Stegloch 261 ausgebildet ist, mit ersten Bereichen der Stege 222 in der Temperierplatte 220 und den darin ausgebildeten ersten Steglöchern 228 korrespondieren.

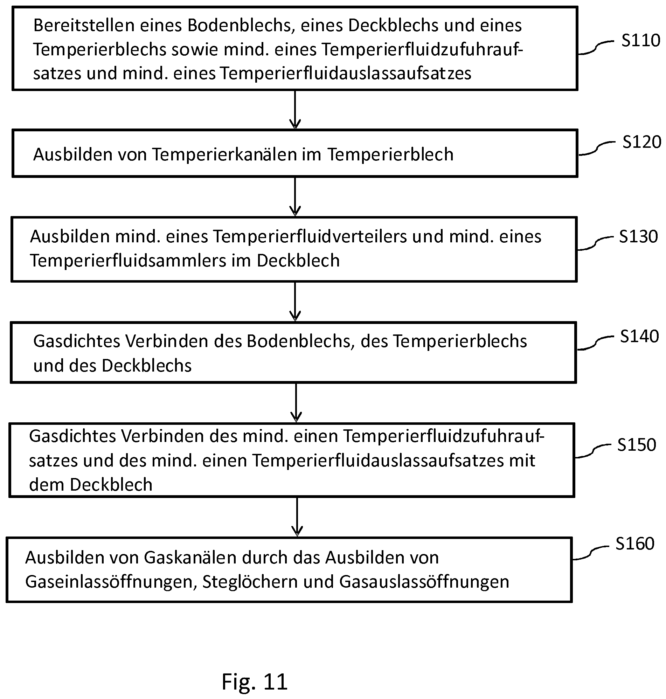

**Figur 11** ist eine schematische Darstellung einer ersten Ausführungsform des erfindungsgemäßen Verfahrens zur Herstellung der ersten Ausführungsform des Gasverteilers. Zunächst werden in Schritt S110 eine Bodenplatte, eine Temperierplatte und eine Deckplatte bereitgestellt, die dieselben Umrisse aufweisen und vorzugsweise deckungsgleich sind. Die Bodenplatte und die Deckplatte weisen dabei keine Gaseinlass- oder Gasauslassöffnungen auf. In der Temperierplatte sind noch keine Steglöcher oder andere, später zu einem Gaskanal gehörende Löcher ausgebildet. Darüber hinaus werden mindestens ein Temperierfluidzufuhraufsatz und mindestens ein Temperierfluidauslassaufsatz bereitgestellt. In einem Schritt S120 wird in der Temperierplatte eine Mehrzahl von Temperierkanälen, wie sie oben beschrieben sind, durch das Ausbilden von Durchbrüchen durch die Temperierplatte ausgebildet. In Schritt S130 werden in der Deckplatte mindestens ein Temperierfluidverteiler und mindestens ein Temperierfluidsammler, wie sie ebenfalls oben beschrieben sind, durch das Ausbilden von Durchbrüchen durch die Deckplatte ausgebildet. Die Schritte S110, S120 und S130 können in beliebiger Reihenfolge oder auch teilweise gleichzeitig ausgeführt werden, so dass in Schritt S110 bereits eine mit den Temperierkanälen versehene Temperierplatte und/oder eine mit dem mindestens einen Temperierfluidverteiler und dem mindestens einen Temperierfluidsammler versehene Deckplatte bereitgestellt werden.

In einem nachfolgenden Schritt S140 werden die Bodenplatte, die Temperierplatte und die Deckplatte miteinander gasdicht mittels eines Fügeverfahrens verbunden. Dabei werden die Kanten der Platten übereinander und die Deckplatte so angeordnet, dass der mindestens eine Temperierfluidverteiler die ersten Enden der mit ihm korrespondierenden Temperierkanäle überdeckt und der mindestens eine Temperierfluidsammler die zweiten Enden der mit ihm korrespondierenden Temperierkanäle überdeckt. Die Deckplatte und die Bodenplatte weisen noch keine Gaseinlass- bzw. Gasauslassöffnungen sowie die Temperierplatte noch keine Steglöcher auf.

In einem Schritt S150 werden der mindestens eine Temperierfluidzufuhraufsatz und der mindestens eine Temperierfluidauslassaufsatz gasdicht mit der Deckplatte verbunden. Dabei werden die Elemente derart zueinander angeordnet, dass der mindestens eine Temperierfluidzufuhraufsatz den mit ihm korrespondierenden Temperierfluidverteiler vollständig bedeckt und der mindestens eine Temperierfluidauslassaufsatz den mit ihm korrespondierenden Temperierfluidsammler vollständig bedeckt.

In einem Schritt S160 werden Gaskanäle ausgebildet, indem in der Deckplatte Gaseinlassöffnungen, in den Stegen der Temperierplatte Steglöcher und in der Bodenplatte Gaslauslassöffnungen in einem gemeinsamen Arbeitsgang ausgebildet werden. Der Schritt S160 kann vor oder nach dem Schritt S150 ausgeführt werden, erfolgt jedoch immer nach dem Schritt S140. Damit können die einzelnen Platten nicht mehr gegeneinander verrutschen und die ausgebildeten Gaskanäle weisen eine glatte Oberfläche und einen geraden Verlauf auf, so dass der Gasdurchtritt nicht behindert wird. Darüber hinaus ist das gemeinsame Ausbilden aller die Gaskanäle bildenden Löcher und Öffnungen einfacher und kostengünstiger zu realisieren als das einzelne Ausbilden der Löcher bzw. Öffnungen in den einzelnen Platten und eine spätere Justierung dieser Löcher und Öffnungen zueinander in einem Schritt zum Verbinden der Platten. Des Weiteren ist mit dem Verfahren bei entsprechenden Genauigkeiten der Fertigungsverfahren zum Ausbilden der Temperierkanäle und zum Ausbilden der Steglöcher die Herstellung eines Gasverteilers mit einer Leckrate gleich Null möglich.

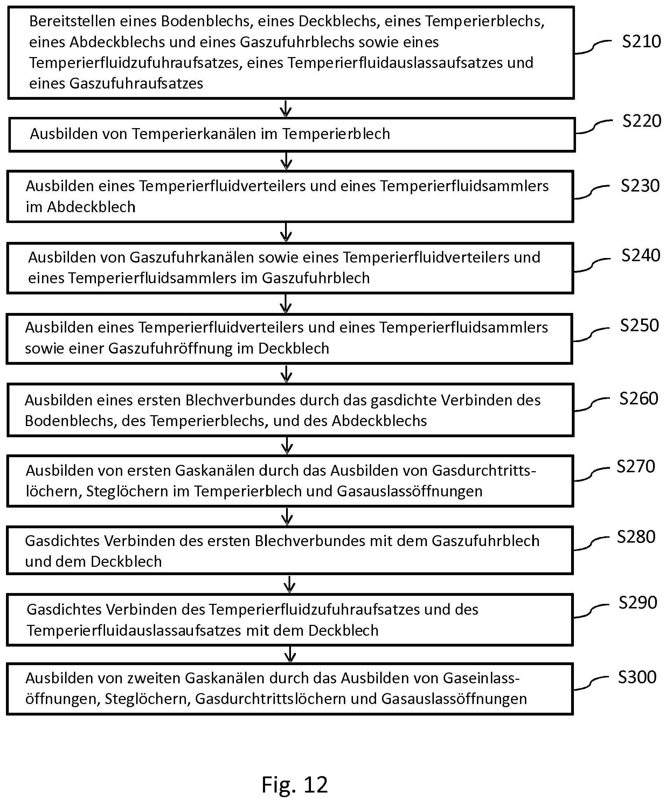

**Figur 12** ist eine schematische Darstellung einer zweiten Ausführungsform des erfindungsgemäßen Verfahrens zur Herstellung eines Beispiels der zweiten Ausführungsform des Gasverteilers, das sich von dem Beispiel der zweiten Ausführungsform des Gasverteilers, die mit Bezug auf die Fig. 5 bis 8 beschrieben ist, nur dadurch unterscheidet, dass der Gasverteiler nur einen Gaszufuhraufsatz und nur eine Gaszufuhröffnung in der Deckplatte aufweist. Zunächst werden in Schritt S210 eine Bodenplatte, eine Temperierplatte, eine Abdeckplatte, eine Gaszufuhrplatte und eine Deckplatte bereitgestellt, die dieselben Umrisse aufweisen und vorzugsweise deckungsgleich sind. Die Bodenplatte und die Deckplatte weisen dabei keine Gaseinlass- oder Gasauslassöffnungen auf, so wie auch die Temperierplatte und die Gaszufuhrplatte noch keine Steglöcher oder andere, später zu einem Gaskanal gehörende Löcher und die Abdeckplatte noch keine Gasdurchtrittslöcher aufweist. Darüber hinaus werden ein Temperierfluidzufuhraufsatz und ein Temperierfluidauslassaufsatz sowie ein Gaszufuhraufsatz bereitgestellt.

In einem Schritt S220 werden in der Temperierplatte eine Mehrzahl von Temperierkanälen, wie sie oben beschrieben sind, durch das Ausbilden von Durchbrüchen durch die Temperierplatte ausgebildet. In der Abdeckplatte werden in Schritt S230 ein Temperierfluidverteiler und ein Temperierfluidsammler als Durchbrüche durch die Abdeckplatte ausgebildet. Gaszufuhrkanäle sowie ein Temperierfluidverteiler und ein Temperierfluidsammler, wie sie bereits beschrieben wurden, werden in Schritt S240 in der Gaszufuhrplatte als Durchbrüche durch die Gaszufuhrplatte ausgebildet. In Schritt S250 werden in der Deckplatte ein Temperierfluidverteiler und ein Temperierfluidsammler sowie eine Gaszufuhröffnung, wie sie ebenfalls oben beschrieben sind, durch das Ausbilden von Durchbrüchen durch die Deckplatte ausgebildet. Die Schritte S210 bis S250 können in beliebiger Reihenfolge oder auch teilweise gleichzeitig ausgeführt werden, so dass in Schritt S210 bereits eine mit den Temperierkanälen versehene Temperierplatte und/oder eine mit den Gaszufuhrkanälen versehene Gaszufuhrplatte und/oder eine oder mehrere mit dem Temperierfluidverteiler und dem Temperierfluidsammler versehene Platte aus der Gruppe enthaltend die Abdeckplatte, die Gaszufuhrplatte und die Deckplatte und/oder eine mit der Gazufuhröffnung versehene Deckplatte bereitgestellt werden.

In einem nachfolgenden Schritt S260 werden die Bodenplatte, die Temperierplatte und die Abdeckplatte miteinander gasdicht mittels eines Fügeverfahrens verbunden. Dabei entsteht ein erster Plattenverbund, wobei die Kanten der Platten übereinander und die Abdeckplatte so angeordnet werden, dass der Temperierfluidverteiler die ersten Enden der Temperierkanäle überdeckt und der Temperierfluidsammler die zweiten Enden der Temperierkanäle überdeckt. Die Abdeckplatte und die Bodenplatte weisen noch keine Gasdurchtrittslöcher bzw. Gasauslassöffnungen sowie die Temperierplatte noch keine Steglöcher auf.

In einem nachfolgenden Schritt S270 werden im ersten Plattenverbund erste Gaskanäle durch das Ausbilden von ersten Gasdurchtrittslöchern in der Abdeckplatte, ersten Steglöchern in der Temperierplatte und ersten Gasauslassöffnungen in der Bodenplatte in einem gemeinsamen Arbeitsgang erzeugt.

Nachfolgend werden in Schritt S280 der erste Plattenverbund und die Gaszufuhrplatte sowie die Deckplatte gasdicht miteinander mittels eines Fügeverfahrens verbunden, wobei die Kanten der Platten übereinander und die Gaszufuhrplatte und die Deckplatte so angeordnet werden, dass die Temperierfluidverteiler und die Temperierfluidsammler der einzelnen Platten übereinander angeordnet werden sowie die Gaszufuhröffnung in der Deckplatte die ersten Enden der Gaszufuhrkanäle überdeckt. Die Gaszufuhrplatte und die Deckplatte weisen noch keine Stegöcher bzw. Gaseinlassöffnungen auf.

In einem Schritt S290 werden der Temperierfluidzufuhraufsatz und der Temperierfluidauslassaufsatz sowie der Gaszufuhraufsatz gasdicht mit der Deckplatte verbunden. Dabei werden die Elemente derart zueinander angeordnet, dass der Temperierfluidzufuhraufsatz den Temperierfluidverteiler in der Deckplatte vollständig bedeckt, der Temperierfluidauslassaufsatz den Temperierfluidsammler in der Deckplatte vollständig bedeckt und der Gaszufuhraufsatz die Gaszufuhröffnung vollständig bedeckt.

In einem Schritt S300 werden zweite Gaskanäle ausgebildet, indem in der Deckplatte Gaseinlassöffnungen, in den Stegen der Gaszufuhrplatte Steglöcher, in der Abdeckplatte zweite Gasdurchtrittslöcher, in den Stegen der Temperierplatte zweite Steglöcher und in der Bodenplatte zweite Gaslauslassöffnungen in einem gemeinsamen Arbeitsgang ausgebildet werden. Der Schritt S300 kann vor oder nach dem Schritt S290 ausgeführt werden, erfolgt jedoch immer nach dem Schritt S280. Damit können die einzelnen Platten nicht mehr gegeneinander verrutschen.

Die mit dem Verfahren ausgebildeten ersten und zweiten Gaskanäle weisen eine glatte Oberfläche und einen geraden Verlauf auf, so dass der Gasdurchtritt nicht behindert wird. Darüber hinaus ist das gemeinsame Ausbilden aller die ersten bzw. zweiten Gaskanäle bildenden Löcher und Öffnungen einfacher und kostengünstiger zu realisieren als das einzelne Ausbilden der Löcher bzw. Öffnungen in den einzelnen Platten und eine spätere Justierung dieser Löcher und Öffnungen zueinander in einem Schritt zum Verbinden der Platten. Des Weiteren ist mit dem Verfahren bei entsprechenden Genauigkeiten der Fertigungsverfahren zum Ausbilden der Temperierkanäle und der Gaszufuhrkanäle und zum Ausbilden der Steglöcher die Herstellung eines Gasverteilers für mehrere Gase mit einer Leckrate gleich Null möglich.

Optional kann nach Schritt S140 und vor Schritt S160 bzw. nach Schritt S260 und vor Schritt S270 ein Schritt zum Überprüfen der Dichtheit des jeweiligen Plattenverbundes gegenüber einem Temperierfluid geprüft werden. Dazu wird ein Temperierfluid durch den Temperierfluidverteiler in die Temperierkanäle eingeleitet.

Es sind verschiedene Erweiterungen des Verfahrens möglich, um verschiedenste Ausführungsformen des erfindungsgemäßen Gasverteilers herzustellen, welche jedoch von einem Fachmann auf der Grundlage der hier dargestellten Ausführungsformen ohne Weiteres zu erkennen und zu implementieren sind.

### Bezugszeichen

- 100: Beispiel für eine erste Ausführungsform des Gasverteilers
- 110: Bodenplatte
- 111: Gasauslassöffnung
- 120: Temperierplatte
- 121: Temperierkanal
- 122: Steg in der Temperierplatte
- 1221: Erster Bereich des Steges
- 1222: Zweiter Bereich des Steges
- 123: Erstes Ende eines Temperierkanals
- 124: Erste Seite der Temperierplatte
- 125: Zweites Ende eines Temperierkanals
- 126: Zweite Seite der Temperierplatte
- 127: Außenkante der Temperierplatte an zweiter Seite
- 128: Stegloch
- 130: Deckplatte
- 131: Erste Seite der Deckplatte
- 132: Zweite Seite der Deckplatte
- 133: Gaseinlassöffnung
- 134, 134a-c: Temperierfluidverteiler
- 135: Temperierfluidsammler
- 136, 137: Außenkante der Deckplatte
- 140, 140a-c: Temperierfluidzufuhraufsatz
- 141: Temperierfluidzufuhranschluss
- 150: Temperierfluidauslassaufsatz
- 151: Temperierfluidauslassanschluss
- 160: Befestigungsloch
- 200: Beispiel für eine zweite Ausführungsform des Gasverteilers
- 210: Bodenplatte
- 211: Erstes Gasauslassöffnung
- 212: Zweites Gasauslassöffnung
- 220: Temperierplatte
- 221: Temperierkanal
- 222: Steg in der Temperierplatte
- 223: Erstes Ende eines Temperierkanals
- 224: Erste Seite der Temperierplatte
- 225: Zweites Ende eines Temperierkanals
- 226: Zweite Seite der Temperierplatte
- 227: Außenkante der Temperierplatte an zweiter Seite
- 228: Erstes Stegloch
- 229: Zweites Stegloch
- 230: Deckplatte
- 231: Temperierfluidverteiler
- 232: Erste Seite der Deckplatte
- 233: Temperierfluidsammler
- 234: Zweite Seite der Deckplatte
- 235: Erste Gaszufuhröffnung
- 236: Dritte Seite der Deckplatte
- 237: Zweite Gaszufuhröffnung
- 238: Vierte Seite der Deckplatte
- 239: Gaseinlassöffnung
- 240: Abdeckplatte
- 241: Erstes Gasdurchtrittsloch
- 242: Zweites Gasdurchtrittsloch
- 243: Temperierfluidverteiler
- 244: Temperierfluidsammler
- 250: Gaszufuhrplatte
- 251: Temperierfluidverteiler
- 252: Erste Seite der Gaszufuhrplatte
- 253: Temperierfluidsammler
- 254: Zweite Seite der Gaszufuhrplatte
- 255: Gaszufuhrkanal
- 256: Steg in der Gaszufuhrplatte
- 257: Erstes Ende eines Gaszufuhrkanals
- 258: Dritte Seite der Gaszufuhrplatte
- 259: Zweites Ende eines Gaszufuhrkanals
- 260: Vierte Seite der Gaszufuhrplatte
- 261: Stegloch
- 270: Temperierfluidzufuhraufsatz
- 271: Temperierfluidzufuhranschluss
- 280: Temperierfluidauslassaufsatz
- 281: Temperierfluidauslassanschluss
- 290: erster Gaszufuhraufsatz
- 291: zweiter Gaszufuhraufsatz

## Patentansprüche

1. Gasverteiler (100, 200) mit einer Bodenplatte (110; 210), einer Temperierplatte (120; 220), einer Deckplatte (130, 230), mindestens einem Temperierfluidzufuhraufsatz (140, 270) und mindestens einem Temperierfluidauslassaufsatz (150, 280), wobei
- die Bodenplatte (110, 210), die Temperierplatte (120, 220) und die Deckplatte (130, 230) denselben Umriss aufweisen,
- die Temperierplatte (120, 220) zwischen der Bodenplatte (110, 210) und der Deckplatte (130, 230) angeordnet ist und die Kanten der Platten (110, 120, 130, 210, 220, 230) übereinander abschließen,
- aufeinanderliegende Platten (110, 120, 130, 210, 220, 230) durch ein Fügeverfahren gasdicht miteinander verbunden sind,
- die Bodenplatte (110, 210) Gasauslassöffnungen (111, 211, 212) aufweist, die die Bodenplatte (110, 210) vollständig durchdringen,
- die Temperierplatte (120, 220) Temperierkanäle (121, 221) aufweist, die als voneinander durch Stege (122, 222) getrennte Durchbrüche ausgebildet sind, wobei die Temperierkanäle (121, 221) erste Enden (123, 223) an einer ersten Seite (124, 224) und zweite Enden (125, 225) an einer zweiten Seite (126, 226) der Temperierplatte (120, 220) aufweisen, jedoch nicht vollständig bis zur jeweiligen Seite reichen, wobei die zweite Seite (126, 226) der ersten Seite (124, 224) gegenüberliegt,
- in den Stegen (122, 222) der Temperierplatte (120 220) durchgehende Steglöcher (128, 228, 229) ausgebildet sind, die mit den Gasauslassöffnungen (111, 211, 212) der Bodenplatte (110, 210) korrespondieren,
- die Deckplatte (130, 230) Gaseinlassöffnungen (133, 239) aufweist, die die Deckplatte (130, 230) vollständig durchdringen und mit mindestens einem Teil der Steglöcher (128, 228, 229) der Temperierplatte (120, 220) korrespondieren,
- die Deckplatte (130, 230) mindestens einen Temperierfluidverteiler (134, 231), der als Durchbruch in der Deckplatte (130, 230) ausgeführt ist und die ersten Enden (123, 223) aller mit ihm korrespondierenden Temperierkanäle (121, 221) überdeckt, sowie mindestens einen Temperierfluidsammler (135, 233) aufweist, der als Durchbruch in der Deckplatte (130, 230) ausgeführt ist und die zweiten Enden (125, 225) aller mit ihm korrespondierenden Temperierkanäle (121, 221) überdeckt,
- der mindestens eine Temperierfluidzufuhraufsatz (140, 270) mit einem Temperaturfluidzufuhranschluss (141, 271) gasdicht mit der Deckplatte (130, 230) verbunden und so über einem mit ihm korrespondierenden Temperierfluidverteiler (134, 231) angeordnet ist, dass er den Temperierfluidverteiler (134, 231) vollständig bedeckt und ein Temperierfluid vom Temperaturfluidzufuhranschluss (134, 271) durch den Temperierfluidverteiler (134, 231) in die ersten Enden (123, 223) der Temperierkanäle (121, 221) strömen kann, und
- der mindestens eine Temperierfluidauslassaufsatz (150, 280) mit einem Temperaturfluidauslassanschluss (151, 281) gasdicht mit der Deckplatte (130, 230) verbunden und so über einem mit ihm korrespondierenden Temperierfluidsammler (135, 233) angeordnet ist, dass er den Temperierfluidsammler (135, 233) vollständig bedeckt und das Temperierfluid aus den zweiten Enden (125, 225) der Temperierkanäle (121, 221) durch den Temperierfluidsammler (135, 233) in den Temperaturfluidauslassanschluss (151, 281) strömen kann.

2. Gasverteiler (200) nach Anspruch 1, weiterhin aufweisend eine Abdeckplatte (240), eine Gaszufuhrplatte (250) und mindestens einen ersten Gaszufuhraufsatz (290), wobei
- die Abdeckplatte (240) zwischen der Temperierplatte (220) und der Deckplatte (230) angeordnet ist und mindestens einen Temperierfluidverteiler (243) und mindestens einen Temperierfluidsammler (244) sowie Gasdurchtrittslöcher (241, 242) aufweist, wobei der mindestens eine Temperierfluidverteiler (243) und der mindestens eine Temperierfluidsammler (244) als Durchbruch in der Abdeckplatte (240) ausgeführt sind und mit dem mindestens einen Temperierfluidverteiler (231) und dem mindestens einen Temperierfluidsammler (233) der Deckplatte (230) korrespondieren, und die Gasdurchtrittslöcher (241, 242) mit den Steglöchern (228, 229) der Temperierplatte (220) korrespondieren,
- die Gaszufuhrplatte (250) zwischen der Abdeckplatte (240) und der Deckplatte (230) angeordnet ist und mindestens einen Temperierfluidverteiler (251) und mindestens einen Temperierfluidsammler (253) sowie eine Mehrzahl von als Durchbrüche durch die Gaszufuhrplatte (250) ausgebildeten und voneinander durch Stege (256) getrennten Gaszufuhrkanälen (255) aufweist, wobei der mindestens eine Temperierfluidverteiler (251) und der mindestens eine Temperierfluidsammler (253) als Durchbruch in der Gaszufuhrplatte (250) ausgeführt sind und mit dem mindestens einen Temperierfluidverteiler (231) und dem mindestens einen Temperierfluidsammler (233) der Deckplatte (230) korrespondieren, wobei die Gaszufuhrkanäle (255) erste Enden (257) an einer dritten Seite (258) der Gaszufuhrplatte (250) und zweite Enden (259) an einer vierten Seite (260) der Gaszufuhrplatte (250) aufweisen, jedoch nicht vollständig bis zur jeweiligen Seite (258, 260) reichen, wobei die dritte Seite (258) und die vierte Seite (260) verschieden von der ersten (252) und der zweiten Seite (254) der Gaszufuhrplatte (250) sind und die vierte Seite (260) der dritten Seite (258) gegenüberliegt, und wobei jeder Gaszufuhrkanal (255) mindestens ein Gasdurchtrittsloch (241), das nicht mit einer Gaseinlassöffnung (239) der Deckplatte (230) korrespondiert, überdeckt,
- in den Stegen (256) der Gaszufuhrplatte (250) Steglöcher (261) ausgebildet sind, die mit den Gaseinlassöffnungen (239) der Deckplatte (230) und mit den korrespondierenden Gasdurchtrittslöchern (242) korrespondieren, und
- die Deckplatte (230) eine erste Gaszufuhröffnung (235), die als Durchbruch in der Deckplatte (230) ausgeführt ist und die ersten Enden (257) aller Gaszufuhrkanäle (255) überdeckt, aufweist,
- der erste Gaszufuhraufsatz (290) mit einem Gaszufuhranschluss gasdicht mit der Deckplatte (230) verbunden und so über der ersten Gaszufuhröffnung (235) angeordnet ist, dass er die erste Gaszufuhröffnung (235) vollständig bedeckt und ein Gas vom Gaszufuhranschluss durch die erste Gaszufuhröffnung (235) in die ersten Enden (257) der Gaszufuhrkanäle (255) strömen kann.

3. Gasverteiler (200) nach Anspruch 2, **dadurch gekennzeichnet, dass**
- die Deckplatte (230) eine zweite Gaszufuhröffnung (237), die als Durchbruch in der Deckplatte (230) ausgeführt ist und die zweiten Enden (259) aller Gaszufuhrkanäle (255) überdeckt, aufweist,
- der Gasverteiler (200) weiterhin einen zweiten Gaszufuhraufsatz (291) aufweist, der gasdicht mit der Deckplatte (230) verbunden und so über der zweiten Gaszufuhröffnung (237) angeordnet ist, dass er die zweite Gaszufuhröffnung (237) vollständig bedeckt und ein Gas vom Gaszufuhranschluss durch die zweite Gaszufuhröffnung (237) in die zweiten Enden (259) der Gaszufuhrkanäle (255) strömen kann.

4. Gasverteiler (100, 200) nach einem der vorhergehenden Ansprüche, **dadurch gekennzeichnet, dass** die Stege (122, 222) in der Temperierplatte (120, 220) aus dem Material der Temperierplatte (120, 220) bestehen und in allen Bereichen dieselbe Dicke aufweisen wie die Temperierplatte (120, 220).

5. Gasverteiler (100, 200) nach einem der vorhergehenden Ansprüche, **dadurch gekennzeichnet, dass** die Temperierkanäle (121, 221) geradlinig zwischen ihren ersten und zweiten Enden (123, 125, 223, 225) verlaufen.

6. Gasverteiler (100, 200) nach einem der vorhergehenden Ansprüche, **dadurch gekennzeichnet, dass** die Stege (122, 222) in der Temperierplatte (120, 220) in ersten Bereichen, in denen ein Stegloch (128, 228, 229) ausgebildet ist, eine größere Breite aufweisen als in zweiten Bereichen.

7. Gasverteiler (100, 200) nach Anspruch 6, **dadurch gekennzeichnet, dass** die Breite des Materials der Temperierplatte (120, 220), das sich zwischen zwei benachbarten Temperierkanälen (121, 221) befindet, größer als oder gleich der Breite des Materials der Temperierplatte (120, 220), das sich zwischen einem Temperierkanal (121, 221) und einem Stegloch (128, 228, 229) befindet, ist.

8. Gasverteiler (100, 200) nach einem der vorhergehenden Ansprüche, **dadurch gekennzeichnet, dass** die Bodenplatte (110, 210), die Temperierplatte (120, 220) und die Deckplatte (130, 230) aus demselben Material, insbesondere einem Metall, bestehen.

9. Verfahren zur Herstellung eines Gasverteilers (100, 200) mit den Schritten:
a) Bereitstellen einer Bodenplatte (110, 210), einer Temperierplatte (120, 220) und einer Deckplatte (130, 230) sowie mindestens eines Termperierfluidzufuhraufsatzes (140, 270) und mindestens eines Temperierfluidauslassaufsatzes (150, 280), wobei die Bodenplatte (110, 210), die Temperierplatte (120, 220) und die Deckplatte (130, 230) denselben Umriss aufweisen,
b) Ausbilden einer Mehrzahl von Temperierkanälen (121, 221) in der Temperierplatte (120, 220) durch das Ausbilden von Durchbrüchen durch die Temperierplatte (120, 220), wobei die einzelnen Durchbrüche voneinander durch Stege (122, 222) getrennt sind und erste Enden (123, 223) an einer ersten Seite (124, 224) der Temperierplatte (120, 220) und zweite Enden (125, 225) an einer zweiten Seite (126, 226) der Temperierplatte (120, 220) aufweisen, jedoch nicht vollständig bis zur jeweiligen Seite (124, 126, 224, 226) reichen, wobei die zweite Seite (126, 226) der ersten Seite (124, 224) gegenüberliegt,
c) Ausbilden mindestens eines Temperierfluidverteilers (134, 231) und mindestens eines Temperierfluidsammlers (135, 233) in der Deckplatte (130, 230) durch das Ausbilden von Durchbrüchen durch die Deckplatte (130, 230),
d) gasdichtes Verbinden der Bodenplatte (110, 210), der Temperierplatte (120, 220) und der Deckplatte (130, 230) miteinander mittels eines Fügeverfahrens derart, dass die Kanten der Platten (110, 120, 130, 210, 220, 230) übereinander liegen und der mindestens eine Temperierfluidverteiler (134, 231) die ersten Enden (123, 223) aller mit ihm korrespondierenden Temperierkanäle (121, 221) überdeckt und der mindestens eine Temperierfluidsammler (135, 233) die zweiten Enden (125, 225) aller mit ihm korrespondierenden Temperierkanäle (121, 221) überdeckt,
e) gasdichtes Verbinden des mindestens einen Temperierfluidzufuhraufsatzes (140, 270) und des mindestens einen Temperierfluidauslassaufsatzes (150, 280) mit der Deckplatte (130, 230) derart, dass jeder Temperierfluidzufuhraufsatz (140, 270) den mit ihm korrespondierenden Temperierfluidverteiler (134, 231) vollständig bedeckt und jeder Temperierfluidauslassaufsatz (150, 280) den mit ihm korrespondierenden Temperierfluidsammler (135, 233) vollständig bedeckt, und
f) Ausbilden von Gaskanälen durch das Ausbilden von Gaseinlassöffnungen (133, 239) in der Deckplatte (130, 230), Steglöchern (128, 228, 229) in den Stegen (122, 222) der Temperierplatte (120, 220) und Gasauslassöffnungen (111, 211, 212) in der Bodenplatte (110, 210) in einem gemeinsamen Arbeitsgang, wobei die Gaseinlassöffnungen (133, 239) die Deckplatte (130, 230), die Steglöcher (128, 228, 229) die Temperierplatte (120, 220) und die Gasauslassöffnungen (111, 211, 212) die Bodenplatte (110, 210) vollständig durchdringen.

10. Verfahren nach Anspruch 9, **dadurch gekennzeichnet, dass**
- in Schritt a) zusätzlich eine Abdeckplatte (240), eine Gaszufuhrplatte (250) und ein erster Gaszufuhraufsatz (290) bereitgestellt werden, wobei die Abdeckplatte (240) und die Gaszufuhrplatte (250) denselben Umriss wie die Bodenplatte (210), die Temperierplatte (220) und die Deckplatte (230) aufweisen,
- in Schritt c) zusätzlich in der Deckplatte (230) eine erste Gaszufuhröffnung (235) als Durchbruch durch die Deckplatte (230) ausgebildet wird
- in der Abdeckplatte (240) mindestens ein Temperierfluidverteiler (243) und mindestens ein Temperierfluidsammler (244) durch das Ausbilden von Durchbrüchen durch die Abdeckplatte (240) ausgebildet werden, die mit dem mindestens einen Temperierfluidverteiler (231) und dem mindestens einen Temperierfluidsammler (233) in der Deckplatte (230) korrespondieren,
- in der Gaszufuhrplatte (250) mindestens ein Temperierfluidverteiler (251) und mindestens ein Temperierfluidsammler (253) sowie eine Mehrzahl von Gaszufuhrkanälen (255) durch das Ausbilden von Durchbrüchen durch die Gaszufuhrplatte (250) ausgebildet werden, wobei der mindestens eine Temperierfluidverteiler (251) und der mindestens eine Temperierfluidsammler (253) mit dem mindestens einen Temperierfluidverteiler (231) und dem mindestens einen Temperierfluidsammler (233) in der Deckplatte (230) korrespondieren und an einer ersten Seite (252) bzw. einer zweiten Seite (254) der Gaszufuhrplatte (250) ausgebildet werden und die einzelnen Gaszufuhrkanäle (255) voneinander durch Stege (256) getrennt sind und erste Enden (257) an einer dritten Seite (258) der Gaszufuhrplatte (250) und zweite Enden (259) an einer vierten Seite (260) der Gaszufuhrplatte (250) aufweisen, jedoch nicht vollständig bis zur jeweiligen Seite (258, 260) reichen, wobei die dritte Seite (258) und die vierte Seite (260) verschieden von der ersten (252) und der zweiten Seite (254) sind und die vierte Seite (260) der dritten Seite (258) gegenüberliegt,
- Schritt d) in die Teilschritte d1), d2) und d3) aufgeteilt wird, wobei
• in Schritt d1) die Bodenplatte (210), die Temperierplatte (220) und die Abdeckplatte (240) mittels eines Fügeverfahrens gasdicht miteinander verbunden werden derart, dass die Kanten der Platten (210, 220, 240) übereinander liegen und der mindestens eine Temperierfluidverteiler (243) in der Abdeckplatte (240) die ersten Enden (223) aller mit ihm korrespondierenden Temperierkanäle (221) überdeckt und der mindestens eine Temperierfluidsammler (244) in der Abdeckplatte (240) die zweiten Enden (225) aller mit ihm korrespondierenden Temperierkanäle (221) überdeckt, wobei ein erster Plattenverbund erzeugt wird,
• in Schritt d2) in der Abdeckplatte (240) erste Gasdurchtrittslöcher (241), in den Stegen (222) der Temperierplatte (220) erste Steglöcher (228) und in der Bodenplatte (210) erste Gasauslassöffnungen (211) in einem gemeinsamen Arbeitsgang ausgebildet werden, wobei die Gasdurchtrittslöcher (241) die Abdeckplatte (240), die Steglöcher (228) die Temperierplatte (220) und die Gasauslassöffnungen (211) die Bodenplatte (210) vollständig durchdringen,
• in Schritt d3) der erste Plattenverbund, die Gaszufuhrplatte (250) und die Deckplatte (230) miteinander mittels eines Fügeverfahrens derart gasdicht miteinander verbunden werden, dass die Kanten der Platten (210, 220, 230, 240, 250) übereinander liegen und die Temperierfluidverteiler (251, 231) sowie die Temperierfluidsammler (253, 233) in der Gaszufuhrplatte (250) und in der Deckplatte (230) mit dem mindestens einen Temperierfluidverteiler (243) und dem mindestens einen Temperierfluidsammler (244) in der Abdeckplatte (240) korrespondieren und die erste Gaszufuhröffnung (235) in der Deckplatte (230) die ersten Enden (257) der Gaszufuhrkanäle (255) vollständig überdeckt,
- in Schritt e) zusätzlich der erste Gaszufuhraufsatz (290) gasdicht mit der Deckplatte (230) verbunden wird derart, dass der Gaszufuhraufsatz (290) die erste Gaszufuhröffnung (235) vollständig bedeckt, und
- in Schritt f) in der Deckplatte (230) die Gaseinlassöffnungen (239), in den Stegen (256) der Gaszufuhrplatte (250) Steglöcher (261) sowie zweite Gasdurchtrittslöcher (242) in der Abdeckplatte (240), zweite Steglöcher (229) in den Stegen (222) der Temperierplatte (220) und zweite Gasauslassöffnungen (212) in der Bodenplatte (210) in einem gemeinsamen Arbeitsgang ausgebildet werden, wobei die Gaseinlassöffnungen (239) die Deckplatte (230), die Steglöcher (261) die Gaszufuhrplatte (250), die zweiten Steglöcher (229) die Temperierplatte (220), die zweiten Gasdurchtrittslöcher (242) die Abdeckplatte (240) und die zweiten Gasauslassöffnungen (212) die Bodenplatte (210) vollständig durchdringen.

11. Verfahren nach Anspruch 9, **dadurch gekennzeichnet, dass** nach Schritt d) und vor Schritt f) ein Schritt zum Überprüfen der Dichtheit des Gasverteilers (100, 200) gegenüber einem Temperierfluid, das durch den mindestens einen Temperierfluidverteiler (134, 231) in die ersten Enden (123, 223) der Temperierkanäle (121, 221), durch die Temperierkanäle (121, 221) und aus den zweiten Enden (125, 225) der Temperierkanäle (121, 221) durch den mindestens einen Temperierfluidsammler (135, 233) strömt, ausgeführt wird.

12. Verfahren nach Anspruch 10, **dadurch gekennzeichnet, dass** nach Schritt d1) und vor Schritt d2) ein Schritt zum Überprüfen der Dichtheit des ersten Plattenverbundes gegenüber einem Temperierfluid, das durch den mindestens einen Temperierfluidverteiler (231) in die ersten Enden (223) der Temperierkanäle (221), durch die Temperierkanäle (221) und aus den zweiten Enden (225) der Temperierkanäle (221) durch den mindestens einen Temperierfluidsammler (233) strömt, ausgeführt wird.

13. Verfahren nach einem der vorhergehenden Ansprüche, **dadurch gekennzeichnet, dass** die Stege (122, 222) in der Temperierplatte (120, 220) so ausgebildet werden, dass sie in allen Bereichen dieselbe Dicke aufweisen wie die Temperierplatte (120, 220).

14. Verfahren nach einem der vorhergehenden Ansprüche, **dadurch gekennzeichnet, dass** die Stege (122, 222) in der Temperierplatte (120, 220) so ausgebildet werden, dass sie in ersten Bereichen, in denen ein Stegloch (128, 228, 229) ausgebildet wurde, eine größere Breite aufweisen als in zweiten Bereichen.

15. Verfahren nach einem der vorhergehenden Ansprüche, **dadurch gekennzeichnet, dass** die Stege (122, 222) in der Temperierplatte (120, 220) so ausgebildet werden, dass die Breite des Materials der Temperierplatte (120, 220), das sich zwischen zwei benachbarten Temperierkanälen (121, 221) befindet, größer als oder gleich der Breite des Materials der Temperierplatte (120, 220), das sich zwischen einem Temperierkanal (121, 221) und einem ausgebildeten Stegloch (128, 228, 229) befindet, ist.

## Claims

1. Gas distributor (100, 200) comprising a base plate (110, 210), a temperature-control plate (120; 220), a top plate (130, 230), at least one temperature-control fluid supply attachment (140, 270) and at least one temperature-control fluid outlet attachment (150, 280), wherein
- the base plate (110, 210), the temperature-control plate (120, 220) and the top plate (130, 230) have the same outline,
- the temperature-control plate (120, 220) is arranged between the base plate (110, 210) and the top plate (130, 230) and the edges of the plates (110, 120, 130, 210, 220, 230) terminate one above the other,
- superposed plates (110, 120, 130, 210, 220, 230) are joined to one another in a gastight manner by a joining method,
- the base plate (110, 210) has gas outlet openings (111, 211, 212) which pass completely through the base plate (110, 210),
- the temperature-control plate (120, 220) has temperature-control channels (121, 221) which are configured as apertures separated from one another by webs (122, 222), wherein the temperature-control channels (121, 221) have first ends (123, 223) on a first side (124, 224) and second ends (125, 225) on a second side (126, 226) of the temperature-control plate (120, 220) but do not extend completely towards the respective side, wherein the second side (126, 226) lies opposite the first side (124, 224),
- web holes (128, 228, 229) passing through the temperature-control plate (120, 220) are formed in the webs (122, 222) of the temperature-control plate (120, 220), which web holes (128, 228, 229) correspond with the gas outlet openings (111, 211, 212) of the base plate (110, 210),
- the top plate (130, 230) has gas inlet openings (133, 239) which completely pass through the top plate (130, 230) and correspond with at least one part of the web holes (128, 228, 229) of the temperature-control plate (120, 220),
- the top plate (130, 230) comprises at least one temperature-control fluid distributor (134, 231) which is executed as an aperture in the top plate (130, 230) and covers the first ends (123, 223) of all the temperature-control channels (121, 221) corresponding therewith, as well as at least one temperature-control fluid collector (135, 233) which is executed as an aperture in the top plate (130, 230) and covers the second ends (125, 225) of all the temperature-control channels (121, 221) corresponding therewith,
- the at least one temperature-control fluid supply attachment (140, 270) with a temperature-control fluid supply connection (141, 271) is connected in a gastight manner to the top plate (130, 230) and is thus arranged over one temperature-control fluid distributor (134, 231) corresponding therewith so that it completely covers the temperature-control fluid distributor (134, 231) and a temperature-control fluid can flow from the temperature-control fluid supply connection (141, 271) through the temperature-control fluid distributor (134, 231) into the first ends (123, 223) of the temperature-control channels (121, 221) and
- the at least one temperature-control fluid outlet attachment (150, 280) with a temperature-control fluid outlet connection (151, 281) is connected in a gastight manner to the top plate (130, 230) and is thus arranged over one temperature-control fluid collector (135, 233) corresponding therewith so that it completely covers the temperature-control fluid collector (135, 233) and the temperature-control fluid can flow from the second ends (125, 225) of the temperature-control channels (121, 221) through the temperature-control fluid collector (135, 233) into the temperature-control fluid outlet connection (151, 281).

2. The gas distributor (200) according to claim 1, further comprising a cover plate (240), a gas supply plate (250) and at least one gas supply attachment (290), wherein
- the cover plate (240) is arranged between the temperature-control plate (220) and the top plate (230) and comprises at least one temperature-control fluid distributor (243) and at least one temperature-control fluid collector (244) as well as gas passage holes (241, 242), wherein the at least one temperature-control fluid distributor (243) and the at least one temperature-control fluid collector (244) are executed as an aperture in the cover plate (240) and correspond with the at least one temperature-control fluid distributor (231) and the at least one temperature-control fluid collector (233) of the top plate (230), and the gas passage holes (241, 242) correspond with the web holes (228, 229) of the temperature-control plate (220),
- the gas supply plate (250) is arranged between the cover plate (240) and the top plate (230) and comprises at least one temperature-control fluid distributor (251) and at least one temperature-control fluid collector (253) as well as a multiplicity of gas supply channels (255) formed as apertures through the gas supply plate (250) and separated from one another by webs (256), wherein the at least one temperature-control fluid distributor (251) and the at least one temperature-control fluid collector (253) are executed as an aperture in the gas supply plate (250) and correspond with the at least one temperature-control fluid distributor (231) and the at least one temperature-control fluid collector (233) of the top plate (230), wherein the gas supply channels (255) have first ends (257) on a third side (258) of the gas supply plate (250) and second ends (259) on a fourth side (260) of the gas supply plate (250) but do not extend completely as far as the respective side (258, 260), wherein the third side (258) and the fourth side (260) are different from the first (252) and the second side (254) of the gas supply plate (250) and the fourth side (260) lies opposite the third side (258), and wherein each gas supply channel (255) covers at least one gas passage hole (241) which does not correspond with a gas inlet opening (239) of the top plate (230),
- web holes (261) are formed in the webs (256) of the gas supply plate (250), which web holes (261) correspond with the gas inlet openings (239) of the top plate (230) and with the corresponding gas passage holes (242) and
- the top plate (230) has a first gas supply opening (235) which is executed as an aperture in the top plate (230) and covers the first ends (257) of all the gas supply channels (255),
- the first gas supply attachment (290) with a gas supply connection is connected in a gastight manner to the top plate (230) and is thus arranged over the first gas supply opening (235) so that it completely covers the first gas supply opening (235) and a gas can flow from the gas supply connection through the first gas supply opening (235) into the first end (257) of the gas supply channels (255).

3. The gas distributor (200) according to claim 2, **characterized in that**
- the top plate (230) has a second gas supply opening (237) which is executed as an aperture in the top plate (230) and covers the second ends (259) of all the gas supply channels (255),
- the gas distributor (200) further has a second gas supply attachment (291) which is connected in a gastight manner to the top plate (230) and is arranged above the second gas supply opening (237) so that it completely covers the second gas supply opening (237) and a gas can flow from the gas supply connection through the second gas supply openings (237) into the second ends (259) of the gas supply channels (255).

4. The gas distributor (100, 200) according to any one of the preceding claims, **characterized in that** the webs (122, 222) in the temperature-control plate (120, 220) consist of the material of the temperature-control plate (120, 220) and in all regions have the same thickness as the temperature-control plate (120, 220).

5. The gas distributor (100, 200) according to any one of the preceding claims, **characterized in that** the temperature-control channels (121, 221) run rectilinearly between their first and second ends (123, 125, 223, 225).

6. The gas distributor (100, 200) according to any one of the preceding claims, **characterized in that** the webs (122, 222) in the temperature-control plate (120, 220) have a greater width in first regions in which a web hole (128, 228, 229) is formed than in second regions.

7. The gas distributor (100, 200) according to claim 6, **characterized in that** the width of the material of the temperature-control plate (120, 220) which is located between two adjacent temperature-control channels (121, 221) is greater than or equal to the width of the material of the temperature-control plate (120, 220) which is located between a temperature-control channel (121, 221) and a web hole (128, 228, 229).

8. The gas distributor (100, 200) according to any one of the preceding claims, **characterized in that** the base plate (110, 210), the temperature-control plate (120, 220) and the top plate (130, 230) consist of the same material, in particular a metal.

9. Method for manufacturing as gas distributor (100, 200) comprising the steps:
a) providing a base plate (110, 210), a temperature-control plate (120, 220) and a top plate (130, 230) as well as at least one temperature-control fluid supply attachment (140, 270) and at least one temperature-control fluid outlet attachment (150, 280), wherein the base plate (110, 210), the temperature-control plate (120, 220) and the top plate (130, 230) have the same outline,
b) forming a plurality of temperature-control channels (121, 221) in the temperature-control plate (120, 220) by forming apertures through the temperature-control plate (120, 220), wherein the individual apertures are separated from one another by webs (122, 222) and have first ends (123, 223) on a first side (124, 224) of the temperature-control plate (120, 220) and second ends (125, 225) on a second side (126, 226) of the temperature-control plate (120, 220) but do not extend completely as far as the respective side (124, 126, 224, 226), wherein the second side (126, 226) lies opposite the first side (124, 224),
c) forming at least one temperature-control fluid distributor (134, 231) and at least one temperature-control fluid collector (135, 233) in the top plate (130, 230) by forming apertures through the top plate (130, 230),
d) gastight joining the base plate (110, 210), the temperature-control plate (120, 220) and the top plate (130, 230) to one another by means of a joining method in such a manner that the edges of the plates (110, 120, 130, 210, 220, 230) lie one above the other and the at least one temperature-control fluid distributor (134, 231) covers the first ends (123, 223) of all the temperature-control channels (121, 221) corresponding therewith and the at least one temperature-control fluid collector (135, 233) covers the second ends (125, 225) of all the temperature-control channels (121, 221) corresponding therewith,
e) gastight connecting the at least one temperature-control fluid supply attachment (140, 270) and the at least one temperature-control fluid outlet attachment (150, 280) to the top plate (130, 230) in such a manner that each temperature-control fluid supply attachment (140, 270) completely covers the temperature-control fluid distributor (134, 231) corresponding therewith and each temperature-control fluid outlet attachment (150, 280) completely covers the temperature-control fluid collector (135, 233) corresponding therewith and
f) forming gas channels by forming gas inlet openings (133, 239) in the top plate (130, 230), web holes (128, 228, 229) in the webs (122, 222) of the temperature-control plate (120, 220) and gas outlet openings (111, 211, 212) in the base plate (110, 210) in a joint operation, wherein the gas inlet openings (133, 239) completely pass through the top plate (130, 230), the web holes (128, 228, 229) completely pass through the temperature-control plate (120, 220) and the gas outlet openings (111, 211, 212) completely pass through the base plate (110, 210).

10. The method according to claim 9, **characterized in that**
- in step a) a cover plate (240), a gas supply plate (250) and a first gas supply attachment (290) are additionally provided, wherein the cover plate (240) and the gas supply plate (250) have the same outline as the base plate (210), the temperature-control plate (220) and the top plate (230),
- in step c) a first gas supply opening (235) is additionally formed in the top plate (230) as an aperture through the top plate (230),
- in the cover plate (240) at least one temperature-control fluid distributor (243) and at least one temperature-control fluid collector (244) are formed by forming apertures through the cover plate (240), which correspond with the at least one temperature-control fluid distributor (231) and the at least one temperature-control fluid collector (233) in the top plate (230),
- in the gas supply plate (250) at least one temperature-control fluid distributor (251) and at least one temperature-control fluid collector (253) as well as a multiplicity of gas supply channels (255) are formed by forming apertures through the gas supply plate (250), wherein the at least one temperature-control fluid distributor (251) and the at least one temperature-control fluid collector (253) correspond with the at least one temperature-control fluid distributor (231) and the at least one temperature-control fluid collector (233) in the top plate (230) and are formed on a first side (252) or a second side (254) of the gas supply plate (250), respectively, and the individual gas supply channels (255) are separated from one another by webs (256) and have first ends (257) on a third side (258) of the gas supply plate (250) and second ends (259) on a fourth side (260) of the gas supply plate (250) but do not extend completely as far as the respective side (258, 260), wherein the third side (258) and the fourth side (260) are different from the first (252) and the second side (254) and the fourth side (260) lies opposite the third side (258),
- step d) is divided into substeps d1), d2) and d3), wherein
• in step d1) the base plate (210), the temperature-control plate (220) and the cover plate (240) are joined to one another in a gastight manner by means of a joining process in such a manner that the edges of the plates (210, 220, 240) lie one above the other and the at least one temperature-control fluid distributor (243) in the cover plate (240) covers the first ends (223) of all the temperature-control channels (221) corresponding therewith and the at least one temperature-control fluid collector (244) in the cover plate (240) covers the second ends (225) of all the temperature-control channels (221) corresponding therewith, wherein a first plate combination is produced,
• in step d2) first gas passage holes (241) in the cover plate (240), first web holes (228) in the webs (222) of the temperature-control plate (220) and first gas outlet openings (211) in the base plate (210) are formed in a joint operation, wherein the gas passage holes (241) pass completely through the cover plate (240), the web holes (228) pass completely through the temperature-control plate (220) and the gas outlet openings (211) pass completely through the base plate (210),
• in step d3) the first plate combination, the gas supply plate (250) and the top plate (230) are joined to one another in a gastight manner by means of a joining method in such a manner that the edges of the plates (210, 220, 230, 240, 250) lie one above the other and the temperature-control fluid distributors (251, 231) and the temperature-control fluid collectors (253, 233) in the gas supply plate (250) and in the top plate (230) correspond with the at least one temperature-control fluid distributor (243) and the at least one temperature-control fluid collector (244) in the cover plate (240) and the first gas supply opening (235) in the top plate (230) completely covers the first ends (257) of the gas supply channels (255),
- in step e) the first gas supply attachment (290) is additionally connected in a gastight manner to the top plate (230) in such a manner that the gas supply attachment (290) completely covers the first gas supply opening (235), and
- in step f) the gas inlet openings (239) in the top plate (230), web holes (261) in the webs (256) of the gas supply plate (250) and second gas passage holes (242) in the cover plate (240), second web holes (229) in the webs (222) of the temperature-control plate (220) and second gas outlet openings (212) in the base plate (210) are formed in a joint operation, wherein the gas inlet openings (239) completely pass through the top plate (230), the web holes (261) completely pass through the gas supply plate (250), the second web holes (229) completely pass through the temperature-control plate (220), the second gas passage holes (242) completely pass through the cover plate (240) and the second gas outlet openings (212) completely pass through the base plate (210).

11. The method according to claim 9, **characterized in that** after step d) and before step f) a step is carried out to check the tightness of the gas distributor (100, 200) with respect to a temperature-control fluid, which flows through the at least one temperature-control fluid distributor (134, 231) into the first ends (123, 223) of the temperature-control channels (121, 221), through the temperature-control channels (121, 221) and out from the second ends (125, 225) of the temperature-control channels (121, 221) through the at least one temperature-control fluid collector (135, 233).

12. The method according to claim 10, **characterized in that** after step d1) and before step d2) a step is carried out to check the tightness of the first plate combination with respect to a temperature-control fluid, which flows through the at least one temperature-control fluid distributor (231) into the first ends (223) of the temperature-control channels (221), through the temperature-control channels (221) and out from the second ends (225) of the temperature-control channels (221) through the at least one temperature-control fluid collector (233).

13. The method according to any one of the preceding claims, **characterized in that** the webs (122, 222) in the temperature-control plate (120, 220) are configured so that they have the same thickness as the temperature-control plate (120, 220) in all regions.

14. The method according to any one of the preceding claims, **characterized in that** the webs (122, 222) in the temperature-control plate (120, 220) are configured so that in first regions in which a web hole (128, 228, 229) is formed they have a greater thickness than in second regions.

15. The method according to any one of the preceding claims, **characterized in that** the webs (122, 222) in the temperature-control plate (120, 220) are configured so that the width of the material of the temperature-control plate (120, 220) which is located between two adjacent temperature-control channels (121, 221) is greater than or equal to the width of the material of the temperature-control plate (120, 220) which is located between a temperature-control channel (121, 221) and a formed web hole (128, 228, 229).

## Revendications

1. Distributeur de gaz (100, 200) composé d'une plaque inférieure (110, 210), d'une plaque de tempérage (120, 220), d'une plaque supérieure (130, 230), d'au moins un embout d'admission de fluide de tempérage (140, 270) et d'au moins un embout de sortie de fluide de tempérage (150, 280), sachant que
- La plaque inférieure (110, 210), la plaque de tempérage (120, 220) et la plaque supérieure (130, 230) présentent le même contour,
- La plaque de tempérage (120, 220) est placée entre la plaque inférieure (110, 210) et la plaque supérieure (130, 230) et les arêtes des plaques (110, 120, 130, 210, 220, 230) sont superposées,
- Les plaques superposées (110, 120, 130, 210, 220, 230) sont reliées entre elles par le biais d'un procédé de jonction hermétique au gaz,
- La plaque inférieure (110, 210) présente des ouvertures de sortie de gaz (111, 211, 212) qui traversent entièrement la plaque inférieure (110, 210),
- La plaque de tempérage (120, 220) présente des canaux de tempérage (121, 221) qui forment des percées séparées les unes des autres par des traverses (122, 222), sachant que les canaux de tempérage (121, 221) présentent une première extrémité (123, 223) sur un premier côté (124, 224) et une deuxième extrémité (125, 225) sur un deuxième côté (126, 226) de la plaque de tempérage (120, 220) sans toutefois aller jusqu'au bout de chacun des deux côtés, sachant que le deuxième côté (126, 226) est opposé au premier côté (124, 224),
- Des perforations (128, 228, 229) sont réalisées dans les traverses (122, 222) de la plaque de tempérage (120, 220), lesquelles correspondent aux ouvertures de sortie de gaz (111, 211, 212) de la plaque inférieure (110, 210),
- La plaque supérieure (130, 230) présente des ouvertures d'entrée de gaz (133, 239) qui traversent entièrement la plaque supérieure (130, 230) et correspondent avec au moins une partie des perforations (128, 228, 229) de la plaque de tempérage (120, 220),
- La plaque supérieure (130, 230) recouvre au moins un distributeur de fluide de tempérage (134, 231) qui consiste en une percée dans la plaque supérieure (130, 230) et les premières extrémités (123, 223) de tous les canaux de tempérage (121, 221) correspondant avec lui, et présente au moins un collecteur de fluide de tempérage (135, 233) consistant en une percée dans la plaque supérieure (130, 230) et qui recouvre les deuxièmes extrémités (125, 225) de tous les canaux de tempérage (121, 221) correspondant avec lui,
- L'embout d'admission de fluide de tempérage (140, 270), au moins au nombre d'un, est relié de façon hermétique au gaz à la plaque supérieure (130, 230) par un raccord d'admission de fluide de tempérage (141, 271) et est disposé de telle sorte au-dessus d'un distributeur de fluide de tempérage (134, 231) correspondant avec lui qu'il recouvre entièrement le distributeur de fluide de tempérage (134, 231) et qu'un fluide de tempérage puisse circuler du raccord d'admission de fluide de tempérage (134, 271) dans les premières extrémités (123, 223) des canaux de tempérage (121, 221) à travers le distributeur de fluide de tempérage (134, 231), et
- L'embout de sortie de fluide de tempérage (150, 280), au moins au nombre d'un, est relié de façon hermétique au gaz à la plaque supérieure (130, 230) par un raccord d'admission de fluide de tempérage (151, 281) et est disposé de telle sorte au-dessus d'un collecteur de fluide de tempérage (135, 233) correspondant avec lui qu'il recouvre entièrement le collecteur de fluide de tempérage (135, 233) et qu'un fluide de tempérage puisse circuler des deuxièmes extrémités (125, 225) des canaux de tempérage (121, 221) dans le raccord de sortie de fluide de tempérage (151, 281) à travers le collecteur de fluide de tempérage (135, 233).

2. Distributeur de gaz (200) selon la revendication 1, présentant également une plaque de recouvrement (240), une plaque d'admission de gaz (250) et au moins un premier embout d'admission de gaz (290), sachant que
- La plaque de recouvrement (240) est disposée entre la plaque de tempérage (220) et la plaque supérieure (230) et présente au moins un distributeur de fluide de tempérage (243) et au moins un collecteur de fluide de tempérage (244) ainsi que des trous de passage de gaz (241, 242), sachant que le distributeur de fluide de tempérage (243), au moins au nombre d'un et le collecteur de fluide de tempérage (244), au moins au nombre de un consistent en une percée dans la plaque de recouvrement (240) et correspondent avec le distributeur de fluide de tempérage (231), au moins au nombre de un, et le collecteur de fluide de tempérage (233), au moins au nombre d'un, de la plaque supérieure (230) et que les trous de passage de gaz (241, 242) correspondent avec les perforations de traverse (228, 229) de la plaque de tempérage (220),
- La plaque d'admission de gaz (250) est disposée entre la plaque de recouvrement (240) et la plaque supérieure (230) et présente au moins un distributeur de fluide de tempérage (251) et au moins un collecteur de fluide de tempérage (253) ainsi que plusieurs canaux d'admission de gaz (255) formés par des percées dans la plaque d'admission de gaz (250) et séparés les uns des autres par des traverses (256), sachant que le distributeur de fluide de tempérage (251), au moins au nombre d'un, et le collecteur de fluide de gaz (253), au moins au nombre de un, consistent en des percées dans la plaque d'admission de gaz (250) et correspondent avec le distributeur de fluide de tempérage (231), au moins au nombre de un, et le collecteur de fluide de tempérage (233), au moins au nombre d'un, de la plaque supérieure (230), sachant que les canaux d'admission de gaz (255) présentent des premières extrémités (257) sur un troisième côté (258) de la plaque d'admission de gaz (250) et des deuxièmes extrémités (259) sur un quatrième côté (260) de la plaque d'admission de gaz (250), mais qui ne vont pas jusqu'au bout de chacun des côtés (258, 260), sachant que le troisième côté (258) et le quatrième côté (260) sont différents du premier côté (252) et du deuxième côté (254) de la plaque d'admission de gaz (250) et que le quatrième côté (260) est opposé au troisième côté (258), et sachant que chaque canal d'admission de gaz (255) recouvre au moins un trou de passage de gaz (241) qui ne correspond pas avec une ouverture d'entrée de gaz (239) de la plaque supérieure (230),
- Des perforations (261) sont pratiquées dans les traverses (256) de la plaque d'admission de gaz (250), lesquelles correspondent avec les ouvertures d'entrée de gaz (239) de la plaque supérieure (230) et les trous de passage de gaz (242) correspondant, et
- La plaque supérieure (230) présente une première ouverture d'admission de gaz (235) qui consiste en une percée dans la plaque supérieure (230) et qui recouvre les premières extrémités (257) de tous les canaux d'admission de gaz (255),
- Le premier embout d'admission de gaz (290) est relié à la plaque supérieure (230) par un raccord d'admission de gaz hermétique au gaz et est disposé au-dessus de la première ouverture d'admission de gaz (235) de telle sorte qu'il recouvre entièrement la première ouverture d'admission de gaz (235) et qu'un gaz puisse s'écouler du raccord d'admission de gaz aux premières extrémités (257) des canaux d'admission de gaz (255) à travers la première ouverture d'admission de gaz (235)

3. Distributeur de gaz (200) selon la revendication 2, **caractérisé par le fait que**
- La plaque supérieure (230) présente une deuxième ouverture d'admission de gaz (237) consistant en une percée dans la plaque supérieure (230) et recouvrant les deuxièmes extrémités (259) de tous les canaux d'admission de gaz (255),
- Le distributeur de gaz (200) présente également un deuxième embout d'admission de gaz (291) relié de façon hermétique à la plaque supérieure (230) et disposée au-dessus de la deuxième ouverture d'admission de gaz (237) de telle sorte qu'il recouvre entièrement la deuxième ouverture d'admission de gaz (237) et qu'un gaz puisse s'écouler du raccord d'admission de gaz aux deuxièmes extrémités (259) des canaux d'admission de gaz (255) à travers la deuxième ouverture d'admission de gaz (237).

4. Distributeur de gaz (100, 200) selon l'une des revendications précédentes, dont la caractéristique est que les traverses (122, 222) de la plaque de tempérage (120, 220) sont fabriquées dans le matériau de la plaque de tempérage (120, 220) et présentent à tous les endroits la même épaisseur que la plaque de tempérage (120, 220).

5. Distributeur de gaz (100, 200) selon l'une des revendications précédentes, dont la caractéristique est que les canaux de tempérage (121, 221) sont rectilignes entre leurs premières et leurs deuxièmes extrémités (123, 125, 223, 225).

6. Distributeur de gaz (100, 200) selon l'une des revendications précédentes, dont en ce que les traverses (122, 222) de la plaque de tempérage (120, 220) présentent une plus grande largeur dans les premières parties dans lesquelles une perforation (128, 228, 229) est pratiquée que dans les deuxièmes parties.

7. Distributeur de gaz (100, 200) selon la revendication 6, dont la caractéristique est que la largeur du matériau de la plaque de tempérage (120, 200) qui se trouve entre deux canaux de tempérage (121, 221) voisins est supérieure ou égale à la largeur du matériau de la plaque de tempérage (120, 220) qui se trouve entre un canal de tempérage (121, 221) et une perforation (128, 228, 229).

8. Distributeur de gaz (100, 200) selon l'une des revendications précédentes, dont la caractéristique est que la plaque inférieure (110, 210), la plaque de tempérage (120, 220) et la plaque supérieure (130, 230) sont fabriquées dans le même matériau, tout particulièrement un métal.

9. Procédé de fabrication d'un distributeur de gaz (100, 200) comportant les étapes suivantes :
a) Mise à disposition d'une plaque inférieure (110, 210), d'une plaque de tempérage (120, 220) et d'une plaque supérieure (130, 230) ainsi que d'au moins un embout d'admission de fluide de tempérage (140, 270) et d'au moins un embout de sortie de fluide de tempérage (150, 280) sachant que la plaque inférieure (110, 210), la plaque de tempérage (120, 220) et la plaque supérieure (130, 230) présentent le même contour,
b) Formation de plusieurs canaux de tempérage (121, 221) dans la plaque de tempérage (120, 220) par la formation de percées à travers la plaque de tempérage (120, 220), sachant que les percées sont séparées les unes des autres par des traverses (122, 222) et présentent des premières extrémités (123, 223) sur un premier côté (124, 224) de la plaque de tempérage (120, 220) et des deuxièmes extrémités (125, 225) sur un deuxième côté (126, 226) de la plaque de tempérage (120, 220), sans toutefois aller jusqu'au bout de chacun des deux côtés (124, 126, 224, 226), sachant que le deuxième côté (126, 226) est opposé au premier côté (124, 224),
c) Formation d'au moins un distributeur de fluide de tempérage (134, 231) et d'au moins un collecteur de fluide de tempérage (135, 233) dans la plaque supérieure (130, 230) par la formation de percées à travers la plaque supérieure (130, 230),
d) Assemblage hermétique de la plaque inférieure (110, 210), de la plaque de tempérage (120, 220) et de la plaque supérieure (130, 230) au moyen d'un procédé de jonction permettant que les arêtes des plaques (110, 120, 130, 210, 220, 230) soient superposées et que le distributeur de fluide de tempérage (134, 231), au moins au nombre d'un, recouvre les premières extrémités (123, 223) de tous les canaux de tempérage (121, 221) qui correspondent avec lui et que le collecteur de fluide de tempérage (135, 233), au moins au nombre de un, recouvre les deuxièmes extrémités (125, 225) de tous les canaux de tempérage (121, 221) qui correspondent avec lui,
e) Liaison hermétique au gaz de l'embout d'admission de fluide de tempérage (140, 270), au moins au nombre d'n, et de l'embout de sortie de fluide de tempérage (150, 280), au moins au nombre d'un, avec la plaque supérieure (130, 230) permettant que chaque embout d'admission de fluide de tempérage (140, 270) recouvre entièrement le distributeur de fluide de tempérage (134, 231) correspondant avec lui et que chaque embout de sortie de fluide de tempérage (150, 280) recouvre entièrement le collecteur de fluide de tempérage (135, 233) qui correspond avec lui, et
f) Formation de canaux de gaz par la formation d'ouvertures d'arrivée de gaz (133, 239) dans la plaque supérieure (130, 230), de perforations (128, 228, 229) dans les traverses (122, 222) des plaques de tempérage (120, 220) et d'ouvertures de sortie de gaz (111, 211, 212) dans la plaque inférieure (110, 210) en une seule opération, sachant que les ouvertures d'entrée de gaz (133, 239) traversent entièrement la plaque supérieure (130, 230), les perforations (128, 228, 229) la plaque de tempérage (120, 220) et les ouvertures de sortie de gaz (111, 211, 212) la plaque inférieure (110, 210).

10. Procédé selon la revendication 9, dont la caractéristique est que
- À l'étape a), une plaque de recouvrement (240), une plaque d'admission de gaz (250) et un premier embout d'admission de gaz (290) sont également mis à disposition, sachant que la plaque de recouvrement (240) et la plaque d'admission de gaz (250) présentent le même contour que la plaque inférieure (210), la plaque de tempérage (220) et la plaque supérieure (230),
- À l'étape c), une première ouverture d'admission de gaz (235) est pratiquée dans la plaque supérieure (230) en guise de percée à travers la plaque supérieure (230)
- Dans la plaque de recouvrement (240), au moins un distributeur de fluide de tempérage (243) et au moins un collecteur de fluide de tempérage (244) sont formés par des percées à travers la plaque de recouvrement (240), lesquels correspondent avec le distributeur de fluide de tempérage (231), au moins au nombre d'un, et le collecteur de fluide de tempérage (233), au moins au nombre de un, de la plaque supérieure (230).
- Au moins un distributeur de fluide de tempérage (251) et au moins un collecteur de fluide de tempérage (253) ainsi que plusieurs canaux d'admission de gaz (255) sont réalisés dans la plaque d'admission de gaz (250) par le biais de percées à travers la plaque de d'admission de gaz (250), sachant que le distributeur de fluide de tempérage (251), au moins au nombre d'un, et le collecteur de fluide de tempérage (253), au moins au nombre d'un, correspondent avec de la plaque supérieure le distributeur de fluide de tempérage (231), au moins au nombre de un, et le collecteur de fluide de tempérage (233), au moins au nombre d'un, de la plaque supérieure (230) et sont réalisés sur un premier côté (252) et un deuxième côté (254) de la plaque d'admission de gaz (250) et les canaux d'admission de gaz (255) sont séparés les uns des autres par des traverses (256) et présentent des premières extrémités (257) sur un troisième côté (258) de la plaque d'admission de gaz (250) et des deuxièmes extrémités (259) sur un quatrième côté (260) de la plaque d'admission de gaz (250), sans aller totalement jusqu'au côté correspondant (258, 260), sachant que le troisième côté (258) et le quatrième côté (260) sont différents du premier (252) et du deuxième côté (254) et que le quatrième côté (260) est opposé au troisième côté (258),
- L'étape d) est divisée en sous-étapes d1), d2) et d3), sachant que
• À l'étape d1), la plaque inférieure (210), la plaque de tempérage (220) et la laque de recouvrement (240) sont assemblées de façon hermétique au gaz au moyen d'un procédé de jonction tel que les arêtes des plaques (210, 220, 240) soient superposées et que le distributeur de fluide de tempérage (243), au moins au nombre d'un, de la plaque de recouvrement (240) recouvre les premières extrémités (223) de tous les canaux de tempérage (221) correspondant avec lui et le collecteur de fluide de tempérage (244), au moins au nombre d'un, de la plaque de recouvrement (240) recouvre les deuxièmes extrémités (225) de tous les canaux de tempérage (221) correspondant avec lui, sachant qu'une première liaison de plaques est réalisée,
• À l'étape d2), les premiers trous de passage de gaz (241) sont réalisés dans la plaque de recouvrement (240), les premières perforations (228) sont réalisées dans les traverses (222) de la plaque de tempérage (220) et les premières ouvertures de sortie de gaz (211) sont réalisées dans la plaque inférieure (210) en une seule opération, sachant que les trous de passage de gaz (241) traversent entièrement la plaque de recouvrement (240), les perforations (228), la plaque de tempérage (220) et les ouvertures de sortie de gaz (211), la plaque inférieure (210),
• À l'étape d3), la première liaison de plaques, la plaque d'admission de gaz (250) et la plaque supérieure (230) sont assemblées de façon hermétique au gaz au moyen d'un procédé de jonction tel que les arêtes des plaques (210, 220, 230, 240, 250) sont superposées et que les distributeurs de fluide de tempérage (251, 231) et les collecteurs de fluide de tempérage (253, 233) de la plaque d'admission de gaz (250) et de la plaque supérieure (230) correspondent avec le distributeur de fluide tempérage (243), au moins au nombre d'un, et le collecteur de fluide de tempérage (244), au moins au nombre d'un, de la plaque de recouvrement (240) et que la première ouverture d'admission de gaz (235) dans la plaque supérieure (230) recouvre entièrement les premières extrémités (257) des canaux d'admission de gaz (255),
- À l'étape e), un embout d'admission de gaz (290) est également relié de façon hermétique à la plaque supérieure (230) de telle sorte que l'embout d'admission de gaz (290) recouvre totalement l'ouverture d'admission de gaz (235), et
- À l'étape f), les ouvertures d'arrivée de gaz (239) sont réalisées dans la plaque supérieure (230), des perforations (261) sont réalisées dans les traverses (256) de la plaque d'admission de gaz (250) ainsi que les deuxièmes trous de passage de gaz (242) dans la plaque de recouvrement (240), les deuxièmes perforations (229) dans les traverses (222) de la plaque de tempérage (220) et les deuxièmes ouvertures de sortie de gaz (212) dans la plaque inférieure (210) en une seule opération, sachant que les ouvertures d'arrivée de gaz (239) traversent entièrement la plaque supérieure (230), les perforations (261), la plaque d'admission de gaz (250), les deuxièmes perforations (229), la plaque de tempérage (220), les deuxièmes trous de passage de gaz (242), la plaque de recouvrement (240) et les deuxièmes ouvertures de sortie de gaz (212), la plaque inférieure (210).

11. Procédé selon la revendication 9, **caractérisé en ce qu'**après l'étape d) et avant l'étape f), une étape de vérification de l'étanchéité du distributeur de gaz (100, 200) à un fluide de tempérage qui s'écoule à travers le distributeur de fluide de tempérage (134, 231), au moins au nombre d'un, dans les premières extrémités (123, 223) des canaux de tempérage (121, 221), à travers les canaux de tempérage (121, 221) et par les deuxièmes extrémités (125, 225) des canaux de tempérage (121, 221) par le collecteur de fluide de tempérage (135, 233), au moins au nombre d'un, est réalisée.

12. Procédé selon la revendication 10, **caractérisé en ce qu'**après l'étape d1) et avant l'étape d2), une étape de vérification de l'étanchéité de la première jonction de plaques à un fluide de tempérage qui s'écoule à travers le distributeur de fluide de tempérage (231), au moins au nombre d'un, dans les premières extrémités (223) des canaux de tempérage (221), à travers les canaux de tempérage (221) et par les deuxièmes extrémités (225) des canaux de tempérage (221) par le collecteur de fluide de tempérage (233), au moins au nombre d'un, est réalisée.

13. Procédé selon l'une des revendications précédentes, **caractérisé en ce que** les traverses (122, 222) sont formées dans la plaque de tempérage (120, 220) de telle sorte qu'elles présentent la même épaisseur que la plaque de tempérage (120, 220) à tous les endroits.

14. Procédé selon l'une des revendications précédentes, dont la caractéristique est que les traverses (122, 222) sont formées dans la plaque de tempérage (120, 220) de telle sorte qu'elles présentent une plus grande largeur dans les premières parties dans lesquelles a été pratiquée une perforation (128, 228, 229) que dans les deuxièmes parties.

15. Procédé selon l'une des revendications précédentes, dont la caractéristique est que les traverses (122, 222) sont réalisées dans la plaque de tempérage (120, 220) de telle sorte que la largeur du matériau de la plaque de tempérage (120, 220) qui se trouve entre deux canaux de tempérage (121, 221) voisins est supérieure ou égale à la largeur du matériau de la plaque de tempérage (120, 220) qui se trouve entre un canal de tempérage (121, 221) et une perforation pratiquée (128, 228, 229).
